# EUROPÄISCHE PATENTSCHRIFT

(11) **EP 1 656 408 B1**
(45) Veröffentlichungstag und Bekanntmachung des Hinweises auf die Patenterteilung: **14.04.2010**
(21) Anmeldenummer: 04764023.0
(22) Anmeldetag: 12.08.2004
(51) Int. Cl.: C08G 61/00, H01L 51/30

(54) **KONJUGIERTE POLYMERE ENTHALTEND DIHYDROPHENANTHREN-EINHEITEN UND DEREN VERWENDUNG**
CONJUGATED POLYMERS CONTAINING DIHYDROPHENANTHRENE UNITS AND USE THEREOF
POLYMERES CONJUGUES RENFERMANT DES MOTIFS DIHYDROPHENANTHRENE, ET LEUR UTILISATION

(30) Priorität: 12.08.2003 DE 10337346
(43) Veröffentlichungstag der Anmeldung: 17.05.2006
(73) Patentinhaber: Merck Patent GmbH, 64293 Darmstadt (DE)
(72) Erfinder: BECKER, Heinrich, 65817 Eppstein-Niederjosbach (DE); BREUNING, Esther, 65527 Niederhausen (DE); BÜSING, Arne, 65929 Frankfurt (DE); LUDERMANN, Aurélie, 60322 Frankfurt (DE); Leske, Corinna, 60529 Frankfurt (DE); SPEITZER, Hubert, 68519 Viernheim (DE); TÜRK, Silke, 56410 Montabaur (DE)
(86) Internationale Anmeldenummer: PCT/EP2004/009019
(87) Internationale Veröffentlichungsnummer: WO 2005/014689

(56) Entgegenhaltungen:
- EP-A- 1 074 600
- EP-A- 1 329 474
- FRANK UCKERT: "Neue lösliche Poly(para-phenylen)-Derivate mit überbrückten Biphenyl-Untereinheiten - Synthese und Anwendung in blauen Leuchtdioden" DISSERTATION, 1998, Seiten 1-210, XP002306981 MAINZ in der Anmeldung erwähnt

## Beschreibung

Seit ca. 12 Jahren läuft eine breit angelegte Forschung zur Kommerzialisierung von Anzeige- und Beleuchtungselementen auf Basis polymerer (organischer) Leuchtdioden (PLEDs). Ausgelöst wurde diese Entwicklung durch die Grundlagenentwicklungen, welche in EP 423 283 (WO 90/13148) offenbart sind. Seit kurzem ist auch ein erstes, wenn auch einfaches, Produkt (eine kleine Anzeige in einem Rasierapparat der Fa. PHILIPS N.V.) auf dem Markt erhältlich. Allerdings sind immer noch deutliche Verbesserungen nötig, um diese Displays zu einer echten Konkurrenz zu den derzeit marktbeherrschenden Flüssigkristallanzeigen (LCD) zu machen bzw. diese zu überflügeln. Vor allem ist es hierbei erforderlich, Polymere für alle Emissionsfarben (Rot, Grün, Blau) zur Verfügung zu stellen, die den Anforderungen des Marktes (Farbsättigung, Effizienz, operative Lebensdauer, um die wichtigsten zu nennen) gerecht werden.

Als Polymere für vollfarbige Anzeigeelemente (sog. Full-Colour-Displays) wurden bereits verschiedene Materialklassen vorgeschlagen bzw. entwickelt. So kommen Poly-Fluoren-Derivate, wie beispielsweise in EP 0842208, WO 99/54385, WO 00/22027, WO 00/22026 und WO 00/46321 offenbart, in Betracht. Des weiteren sind auch Poly-Spirobifluoren-Derivate, wie in EP 0707020, EP 0894107 und WO 03/020790 offenbart, eine Möglichkeit. Auch Polymere, die eine Kombination der beiden erstgenannten Strukturelemente enthalten, wie in WO 02/077060 offenbart, wurden bereits vorgeschlagen. Im allgemeinen sind für derartigen Einsatz Polymere, welche Poly-para-phenylen (PPP) als Strukturelement enthalten, möglich. Neben den oben bereits genannten Klassen kommen hier beispielsweise auch die sogenannten Leiter-PPPs ("Ladder-PPPs" = LPPP) (z. B. gemäß WO 92/18552), die Poly-tetrahydropyrene (z. B. gemäß EP 699699), aber auch Ansa-Strukturen enthaltende PPPs (z. B. gemäß EP 690086) in Frage.

Wie in einigen der o. g. Anmeldeschriften bereits herausgearbeitet wurde, ist es für die Erzeugung aller drei Emissionsfarben notwendig, bestimmte Comonomere in die entsprechenden Polymere einzupolymerisieren (vgl. z. B. WO 00/46321, WO 03/020790 und WO 02/077060). So ist dann in der Regel - ausgehend von einem blau emittierenden Grundpolymer ("backbone") - die Erzeugung der beiden anderen Primärfarben Rot und Grün möglich.

Der allgemeine Aufbau von PLEDs ist in den o. g. Anmeldeschriften bzw. Patenten wiedergegeben und auch weiter unten noch näher erläutert.
Derzeit wird die Kommerzialisierung von sowohl einfarbigen als auch mehr- bzw. vollfarbigen Displays basierend auf PLEDs erwogen. Während die einfarbigen Displays eventuell durch einfache Beschichtungstechnologien (wie z. B. Rakeln, Spin-Coaten) erzeugt werden können, ist bei mehr- bzw. vollfarbigen Anzeigeelementen der Einsatz von Druckverfahren (z. B. Tintenstrahldruck, Off-Set-Druck, Tiefdruckverfahren, Siebdruck-Verfahren) sehr wahrscheinlich. All diese Verfahren benötigen lösliche Polymere.

Die Polymere gemäß den o. g. Anmeldungen zeigen zum Teil schon gute Eigenschaften für die aufgeführten Anwendungen auf. Wichtige Eigenschaften sind hierbei v. a. folgende:
- Hohe Leucht- und Energieeffizienz bei der Verwendung in PLEDs.
- Lange operative Lebensdauer bei der Verwendung in PLEDs.
- Niedrige Betriebsspannung.
- Gute Lagerstabilität, sowohl in der Verwendung in PLEDs, als auch vor deren Einbringen in entsprechende Vorrichtungen.
- Gute Löslichkeit in organischen Lösemitteln, um überhaupt ein entsprechendes Beschichtungsverfahren zu ermöglichen.
- Vernünftige Zugänglichkeit, um die wirtschaftliche Verwendung in Massenprodukten zu ermöglichen.
- Erzielbarkeit verschiedener Farben, um vollfarbige Anzeigeelemente (Displays) zu ermöglichen.

Es wurde nun überraschend gefunden, daß eine neue Klasse von Polymeren, enthaltend substituierte Dihydrophenanthren-Einheiten, sehr gute und den o. g. Stand der Technik übertreffende Eigenschaften aufweist. Diese Polymere und deren Verwendung in PLEDs sind daher Gegenstand der vorliegenden Erfindung.

Unsubstituierte Poly(dihydrophenanthrene) sind bereits in JP 04288322 und von T. Yamamoto et al. (Macromolecules **1992**, *25*, 1214-1223) beschrieben. Durch die fehlende Substitution sowohl an der 9,10-Position, wie auch an den Aromaten, stellen diese Polymere jedoch keine Alternative zu erfindungsgemäßen Polymeren dar, da die unsubstituierten Polymere unlöslich sind und somit nicht aus Lösung verarbeitet werden können. Ebenso beschreibt F. Uckert (Dissertation, Uni Mainz **1998**) die Synthese von Oligo(9,9,10,10-tetramethyl-9,10-dihydrophenanthren). Die Synthese von Polymeren aus diesen Bausteinen war jedoch aufgrund der geringen Löslichkeit ebensowenig möglich wie ein Test der Oligomere in einer PLED. In derselben Arbeit wird die Synthese von Poly[9,10-dimethyl-9,10-bis(pivaloyloxy)-9,10-dihydrophenanthren] beschrieben. Dieses ist zwar gut löslich und zeigt prinzipiell blaue Elektrolumineszenz, durch die hohe Betriebsspannung ist jedoch der Energieverbrauch in einer PLED mit diesem Material zu hoch und die Lebensdauer ist zu gering, so daß auch diese Substituententkombination nicht geeignet ist für die Synthese von hocheffizienten und langlebigen Polymeren.

In EP 1074600 sind alternierende Poly(arylenvinylen)verbindungen beschrieben, wobei die eine Arylen-Einheit ein 9,10-Dialkyl-9,10-dihydrophenanthren und die andere ein substituiertes Phenylen darstellen. Eigenschaften dieses Polymers, insbesondere in der Elektrolumineszenz, werden nicht beschrieben, so dass aus diesem Beispiel nicht hervorgeht, welche speziellen Vorteile dieses Polymer aufweisen soll.

Gegenstand der Erfindung sind konjugierte oder teilkonjugierte Polymere, enthaltend mindestens 1 mol%, bevorzugt mindestens 10 mol%, besonders bevorzugt mindestens 40 mol% Einheiten gemäß Formel (lb), 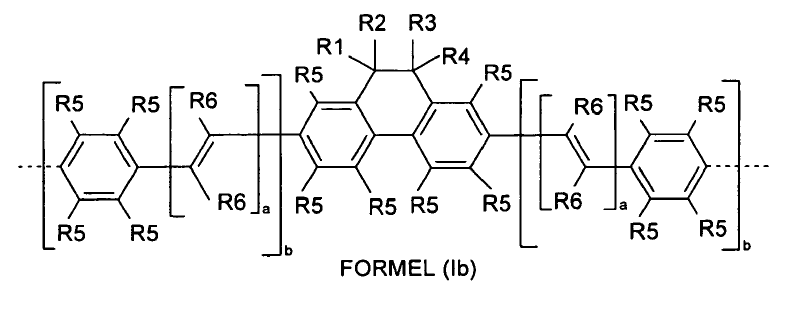 wobei die verwendeten Symbole und Indizes folgende Bedeutung besitzen:
- R1, R2, R3, R4: ist bei jedem Auftreten gleich oder verschieden eine geradkettige, verzweigte oder cyclische Alkyl- oder Alkoxykette mit 1 bis 10 C-Atomen, wobei auch ein oder mehrere H-Atome durch Fluor ersetzt sein können, eine Aryl-, Heteroaryl- oder Aryloxygruppe mit 5 bis 14 C-Atomen, bei der auch ein oder mehrere C-Atome durch O, S oder N ersetzt sein können und welche auch durch ein oder mehrere nicht-aromatische Reste R5 substituiert sein können, mit der Maßgabe, daß nicht zwei Substituenten an einem C-Atom (d. h. R1 und R2 bzw. R3 und R4) gleichzeitig einer Alkoxy- oder Aryloxyseitenkette entsprechen und daß nicht alle Substituenten R1 bis R4 gleichzeitig eine Methylgruppe beschreiben;
- R5: ist bei jedem Auftreten gleich oder verschieden H, F, CN, N(R6)₂ oder B(R6)₂, eine geradkettige, verzweigte oder cyclische Alkyl- oder Alkoxykette mit 1 bis 22 C-Atomen, in der auch ein oder mehrere nicht benachbarte C-Atome durch O, S, CO-O, O-CO-O, CONR6, Si(R6)₂ ersetzt sein können, wobei auch ein oder mehrere H-Atome durch Fluor ersetzt sein können, eine Aryl-, Heteroaryl- oder Aryloxygruppe mit 5 bis 40 C-Atomen, bei der auch ein oder mehrere C-Atome durch O, S oder N ersetzt sein können und welche auch durch einen oder mehrere nicht-aromatische Reste R5 substituiert sein kann; dabei können auch mehrere Reste R5 miteinander oder mit R1 bis R4 ein Ringsystem bilden;
- R6: ist bei jedem Auftreten gleich oder verschieden H, eine geradkettige, verzweigte oder cyclische Alkylkette mit 1 bis 22 C-Atomen, in der auch ein oder mehrere nicht benachbarte C-Atome durch O, S, CO-O, O-CO-O ersetzt sein können, wobei auch ein oder mehrere H-Atome durch Fluor ersetzt sein können, eine Arylgruppe mit 5 bis 40 C-Atomen, bei der auch ein oder mehrere C-Atome durch O, S oder N ersetzt sein können und welche auch durch einen oder mehrere nicht-aromatische Reste R6 substituiert sein kann;
- a: ist bei jedem Auftreten gleich oder verschieden 0 oder 1;
- b: ist bei jedem Auftreten gleich oder verschieden 0, 1 oder 2;
die gestrichelte Bindung bedeutet dabei in Formel (lb) ebenso wie in allen weiteren Formeln die Verknüpfung im Polymer; sie soll hier keine Methylgruppe darstellen.

Auch wenn dies aus der Beschreibung hervorgeht, sei hier nochmal explizit darauf verwiesen, daß die Struktureinheiten gemäß Formel (lb) auch unsymmetrisch substituiert sein können, d. h. an einer Einheit unterschiedliche Substituenten R1 bis R5 vorhanden sein können, bzw. R5 auch unterschiedliche Stellungen auf den beiden Seiten des Biaryls haben kann. Ebenso sei nochmal explizit erwähnt, dass die Reste R1 bis R5 auch miteinander ein Ringsystem bilden können.

Die Polymere können konjugiert oder teilkonjugiert sein. In einer bevorzugten Ausführungsform der Erfindung sind die Polymere konjugiert.

Konjugierte Polymere im Sinne dieser Erfindung sind Polymere, die in der Hauptkette hauptsächlich sp²-hybridisierte Kohlenstoffatome, die auch durch entsprechende Heteroatome ersetzt sein können, enthalten. Dies bedeutet im einfachsten Fall abwechselndes Vorliegen von Doppel- und Einfachbindungen in der Hauptkette. Hauptsächlich meint, daß natürlich auftretende Defekte, die zu Konjugationsunterbrechungen führen, den Begriff "konjugierte Polymere" nicht entwerten. Des weiteren wird in diesem Anmeldetext ebenfalls als konjugiert bezeichnet, wenn sich in der Hauptkette beispielsweise Arylamineinheiten und/oder bestimmte Heterocyclen (d. h. Konjugation über N-, O- oder S-Atome) und/oder metallorganische Komplexe (d. h. Konjugation über das Metallatom) befinden.

Teilkonjugierte Polymere im Sinne dieser Erfindung sind Polymere, die entweder in der Hauptkette längere konjugierte Abschnitte enthalten, die durch nicht-konjugierte Abschnitte unterbrochen sind, oder die in den Seitenketten eines in der Hauptkette nicht-konjugierten Polymers längere konjugierte Abschnitte enthalten. Hingegen würden Einheiten wie beispielsweise einfache (Thio)Etherbrücken, Alkylenketten, Ester-, Amid- oder Imidverknüpfungen eindeutig als nicht-konjugierte Segmente definiert.

Die erfindungsgemäßen Polymere können neben den Einheiten gemäß Formel (lb) noch weitere Strukturelemente enthalten. Dies sind u. a. solche, wie sie in den o. g. Patentanmeldungen bereits offenbart sind. Hier sei vor allem auch auf die relativ umfangreiche Auflistung in der oben schon erwähnten Anmeldeschrift WO 02/077060 verwiesen; diese wird via Zitat als Bestandteil der vorliegenden Erfindung betrachtet. Diese weiteren Struktureinheiten können beispielsweise aus den im folgenden beschriebenen Klassen stammen:
- Gruppe 1:: Einheiten, welche die Lochinjektions- und/oder -transporteigenschaften der Polymere deutlich erhöhen;
- Gruppe 2:: Einheiten, welche die Elektroneninjektions- und/oder -transporteigenschaften der Polymere deutlich erhöhen;
- Gruppe 3:: Einheiten, die Kombinationen von Einzeleinheiten der Gruppe 1 und Gruppe 2 aufweisen;
- Gruppe 4:: Einheiten, welche die Emissionscharakteristik insoweit verändern, daß statt Fluoreszenz Phosphoreszenz erhalten werden kann;
- Gruppe 5:: Einheiten, welche den Übergang vom sogenannten Singulett- zum Triplett-Zustand erleichtern;
- Gruppe 6:: Einheiten, welche die Morphologie oder auch die Emissionsfarbe der resultierenden Polymere beeinflussen;
- Gruppe 7:: Einheiten, welche typischerweise als Backbone verwendet werden.

Bevorzugte erfindungsgemäße Polymere sind solche, bei denen mindestens ein Strukturelement Ladungstransporteigenschaften aufweist, d. h. die Einheiten aus den Gruppen 1 und/oder 2 enthalten. Im Sinne dieses Anmeldetextes soll unter solchen Strukturelementen folgendes verstanden werden: Würde man aus diesen Strukturelementen Homopolymere oder -oligomere erzeugen, hätten diese - zumindest für einen Ladungsträger, d. h. entweder Elektronen oder Löcher - eine höhere Ladungsträgermobilität, als dies bei einem Polymer, welches ausschließlich aus Strukturelementen gemäß Formel (lb) besteht, der Fall ist. Bevorzugt ist die Ladungsträgermobilität (gemessen in cm²/(V*s)) mindestens um einen Faktor 10, besonders bevorzugt mindestens um einen Faktor 50 größer.

Strukturelemente aus der Gruppe 1, die Lochtransporteigenschaften aufweisen, sind beispielsweise Triarylaminderivate, Benzidinderivate, Tetraarylen-para-phenylendiaminderivate, Phenothiazinderivate, Phenoxazinderivate, Dihydrophenazinderivate, Thianthrenderivate, Dibenzo-*p*-dioxinderivate, Phenoxathiinderivate, Carbazolderivate, Azulenderivate, Thiophenderivate, Pyrrolderivate, Furanderivate und weitere O-, S- oder N-haltige Heterocyclen mit hochliegendem HOMO (HOMO = höchstliegendes besetztes Molekülorbital); bevorzugt führen diese Arylamine und Heterocyclen zu einem HOMO im Polymer von weniger als 5.8 eV (gegen Vakuumlevel), besonders bevorzugt von weniger als 5.5 eV.

Bevorzugte Einheiten der Gruppe 1 sind Einheiten gemäß den Formeln (II) bis (XX), 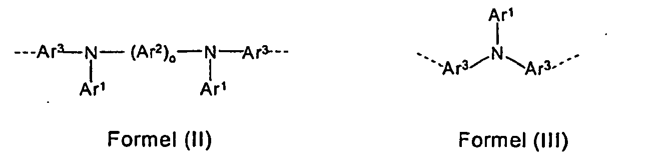 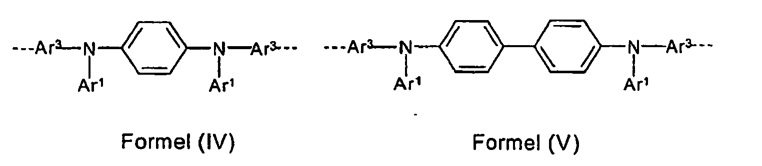 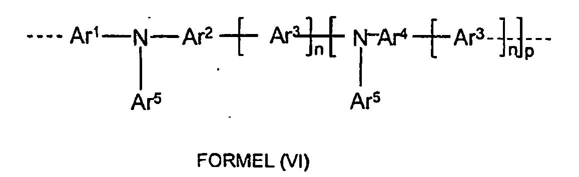 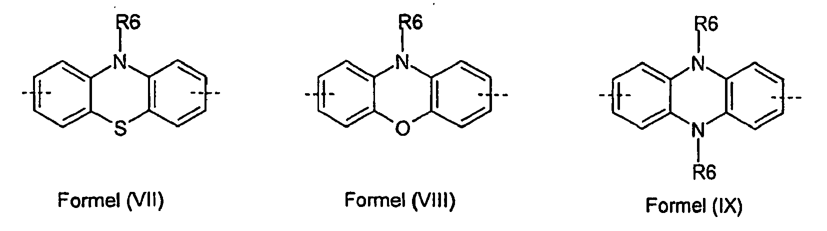 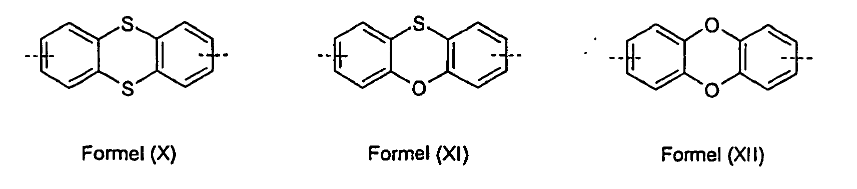 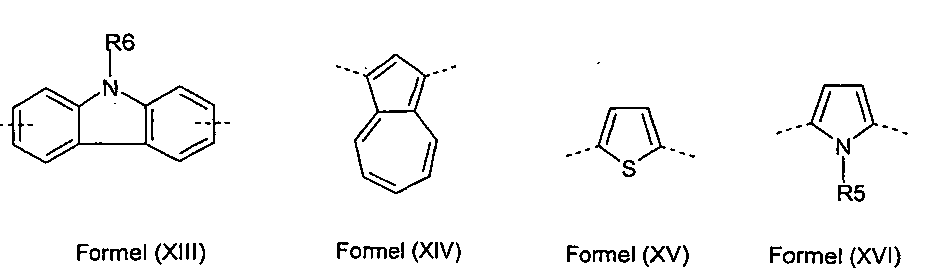 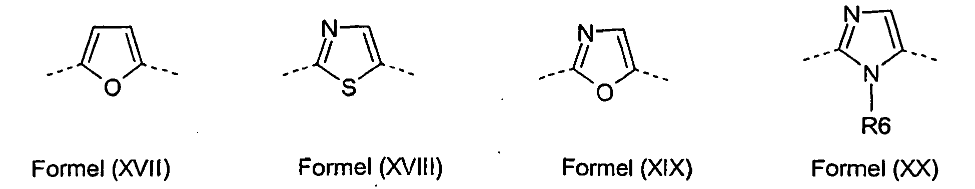 wobei die Substituenten R1 bis R6 die o. g. Bedeutung besitzen, die verschiedenen Formeln an den freien Positionen durch Substituenten R1 substituiert sein können und die Symbole und Indizes folgendes bedeuten:
- n: ist gleich oder verschieden bei jedem Auftreten 0, 1, oder 2;
- p: ist gleich oder verschieden bei jedem Auftreten 0, 1 oder 2, bevorzugt 0 oder 1;
- o: ist gleich oder verschieden bei jedem Auftreten 1, 2 oder 3, bevorzugt 1 oder 2;
- Ar¹, Ar³: sind bei jedem Auftreten gleich oder verschieden einem aromatischen oder heteroaromatischen Ringsystem mit 2 bis 40 C-Atomen, welches substituiert oder auch unsubstituiert sein kann; die möglichen Substituenten R1 können dabei potentiell an jeder freien Position sitzen;
- Ar², Ar⁴: sind bei jedem Auftreten gleich oder verschieden Ar¹, Ar³ oder eine substituierte oder unsubstituierte Stilbenylen- bzw. Tolanyleneinheit;
- Ar⁵: ist gleich oder verschieden bei jedem Auftreten entweder einem System gemäß Ar¹ oder einem aromatischen oder heteroaromatischen Ringsystem mit 9 bis 40 aromatischen Atomen (C- oder Heteroatome), welches substituiert oder unsubstituiert sein kann und welches aus mindestens zwei kondensierten Ringen besteht; die möglichen Substituenten R1 können dabei potentiell an jeder freien Position sitzen.

Strukturelemente aus Gruppe 2, die Elektronentransporteigenschaften aufweisen, sind beispielsweise Pyridinderivate, Pyrimidinderivate, Pyridazinderivate, Pyrazinderivate, Anthracenderivate, Triarylborane, Oxadiazolderivate, Chinolinderivate, Chinoxalinderivate, Phenazinderivate, Aryfborane und weitere O-, S- oder N-haltige Heterocyclen mit niedrig liegendem LUMO (LUMO = niedrigstes unbesetztes Molekülorbital); bevorzugt führen diese Heterocyclen im Polymer zu einem LUMO von mehr als 2.7 eV (gegen Vakuumlevel), besonders bevorzugt von mehr als 3.0 eV.

Bevorzugte Einheiten der Gruppe 2 sind dabei Einheiten gemäß den Formeln (XXI) bis (XXXII), 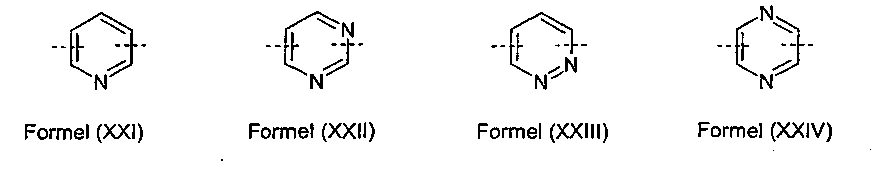 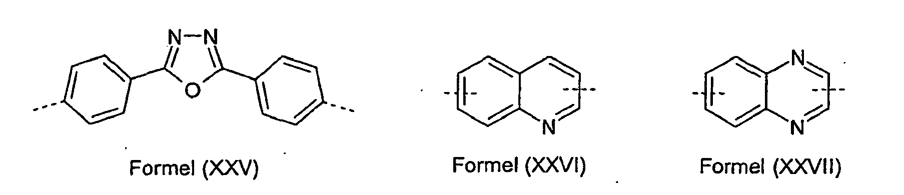 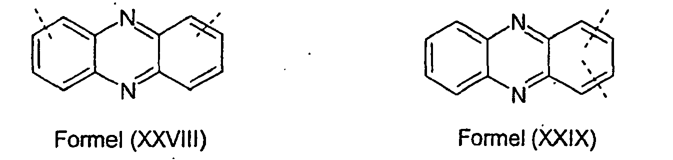 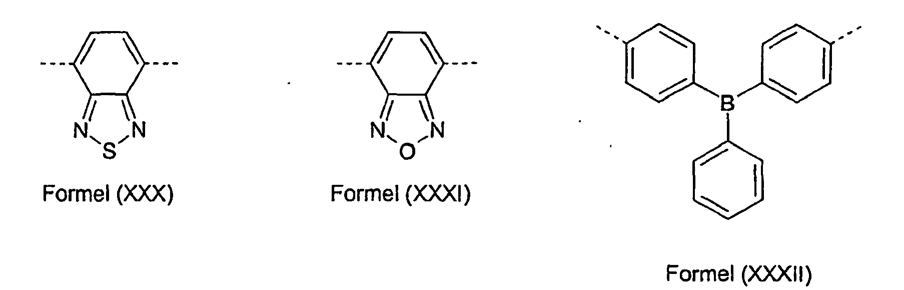 wobei die verschiedenen Formeln an den freien Positionen durch Substituenten R1 substituiert sein können.

Es kann bevorzugt sein, wenn in den erfindungsgemäßen Polymeren Einheiten aus Gruppe 3 enthalten sind, in denen Einheiten, welche die Lochmobilität und welche die Elektronenmobilität erhöhen, direkt aneinander gebunden sind. Dies sind unter anderem Einheiten gemäß den Formeln (XXXIII) bis (XXXXVII), bzw. etwas allgemeiner gemäß Formel (XXXXVIII), die sowohl eine oder mehrere Strukturen gemäß den Formeln (II) bis (XX), als auch eine oder mehrere Strukturen gemäß den Formeln (XXI) bis (XXXII) enthalten, wobei die verschiedenen Formeln an den freien Positionen durch Substituenten R1 substituiert sein können und die Symbole R1, R2, R3, R4, R5, Ar¹ und Indizes n, p und o die oben genannte Bedeutung besitzen und Y bei jedem Auftreten gleich oder verschieden O, S, Se, N, P, Si oder Ge ist. Es sei allerdings darauf verwiesen, daß es natürlich für den Fachmann ein leichtes ist, aus den o. g. Strukturen (II) bis (XX) bzw. (XXI) bis (XXXII) weitere geeignete Kombinationen zu synthetisieren und diese in die erfindungsgemäßen Polymere zu inkorporieren.

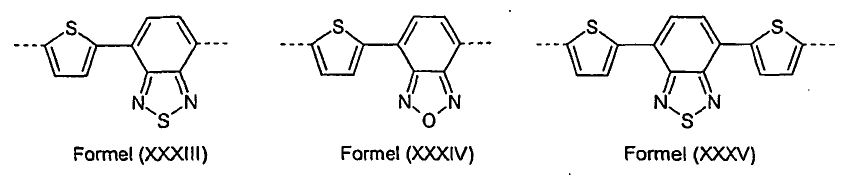

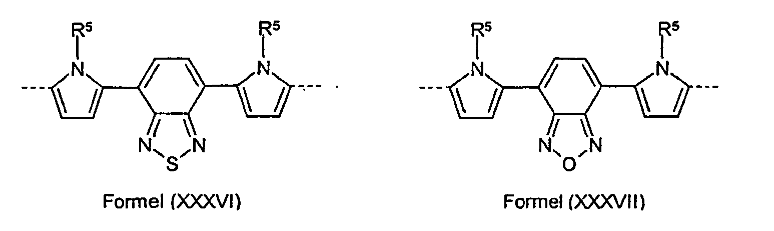

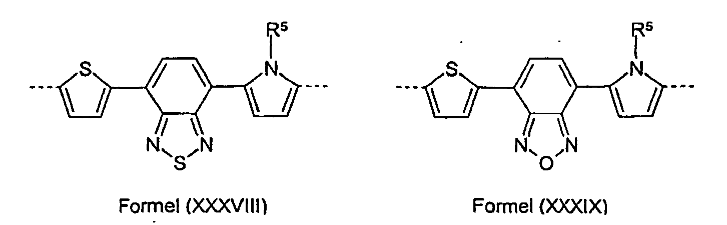

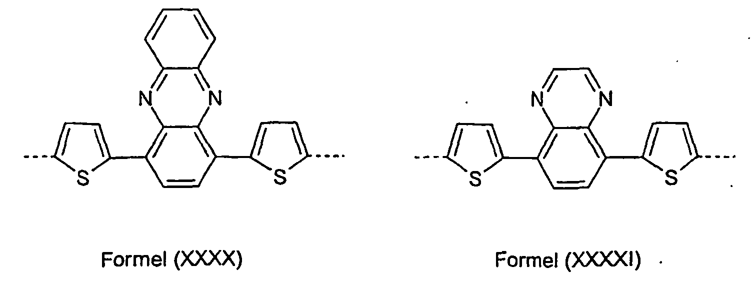

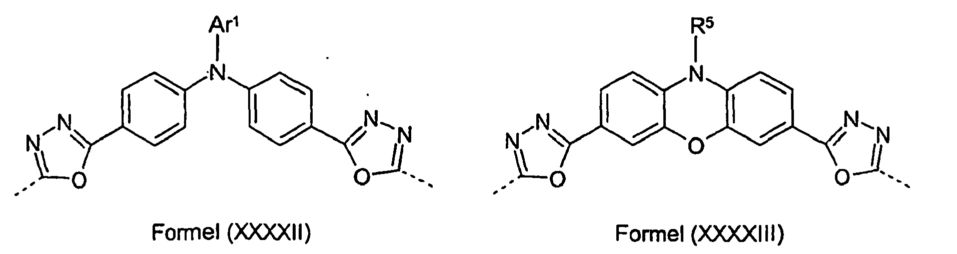

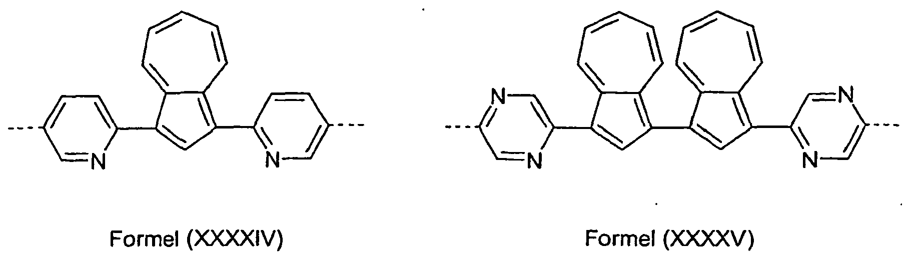

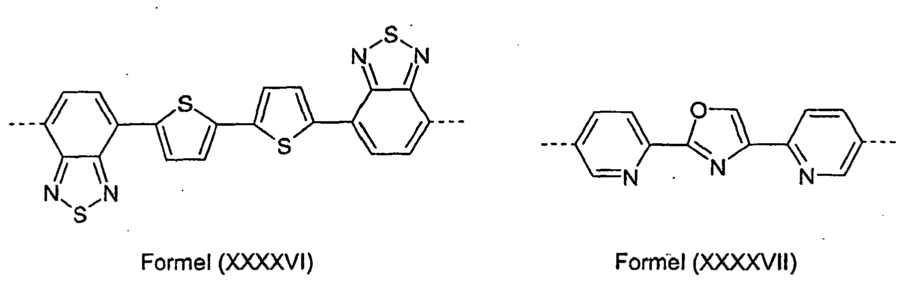

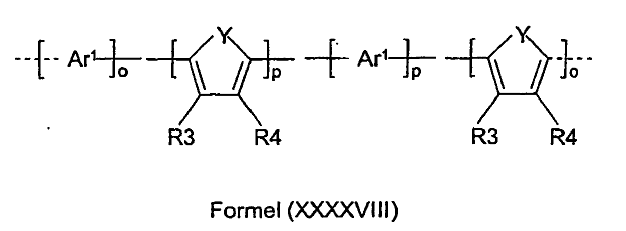

Struktureinheiten gemäß Gruppe 4 sind solche, welche einen Transfer von sogenannten Singulett-Excitonen zu Triplett-Excitonen ermöglichen und welche auch bei Raumtemperatur mit hoher Effizienz aus dem Triplettzustand Licht emittieren können, also Elektrophosphoreszenz statt Elektrofluoreszenz zeigen, was häufig eine Steigerung der Energieeffizienz bewirkt. Die Verwendung derartiger Metallkomplexe in niedermolekularen OLEDs ist beispielsweise in M. A. Baldo, S. Lamansky, P. E. Burrows, M. E. Thompson, S. R. Forrest, Appl. Phys. Lett. 1999, 75, 4-6 beschrieben.
- Hierfür eignen sich zunächst Verbindungen, welche Schweratome, d. h. Atome aus dem Periodensystem der Elemente mit einer Ordnungszahl von mehr als 36, enthalten.
- Besonders geeignet hierfür sind Verbindungen, welche d- und f-Übergangsmetalle beeinhalten, die die o. g. Bedingung erfüllen. Ganz besonders bevorzugt scheinen hier entsprechende Struktureinheiten, welche Elemente der Gruppe 8 bis 10 (d. h. Ru, Os, Rh, Ir, Pd, Pt) enthalten.
- Als Struktureinheiten für die erfindungsgemäßen Polymeren kommen verschiedene Komplexe in Frage, welche beispielsweise in den Anmeldeschriften WO 02/068435, WO 02/081488, EP 1239526 und WO 04/026886 beschrieben sind.

Entsprechende Monomere sind in der Anmeldeschrift WO 02/068435 beschrieben. Bevorzugte Einheiten der Gruppe 4 sind Einheiten gemäß den Formeln (XXXXIX) bis (LVI), 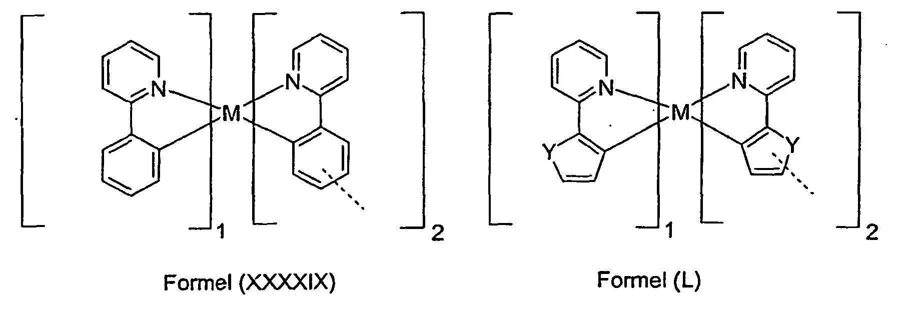 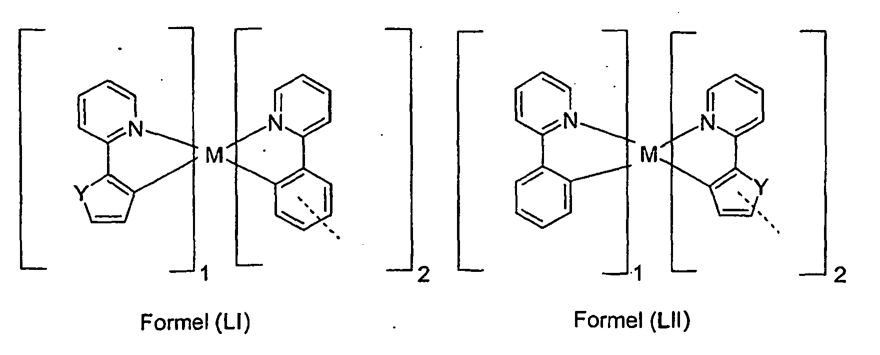 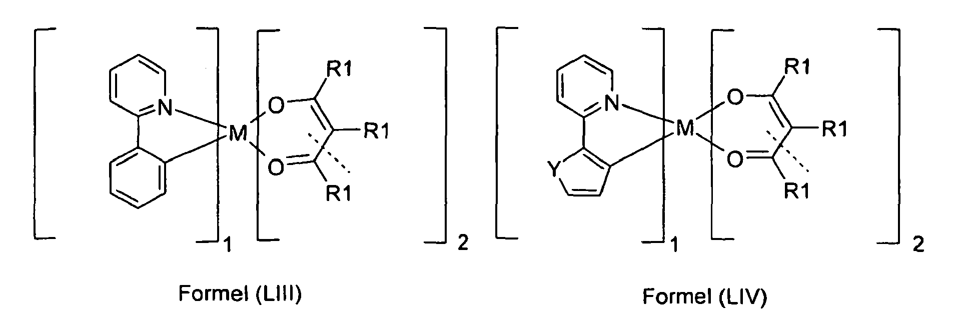 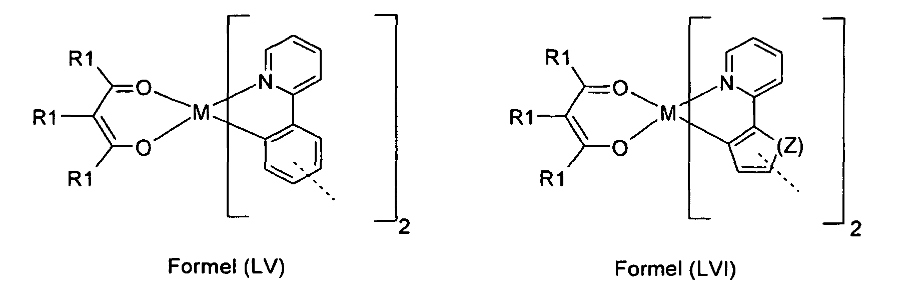 wobei die Strukturen an den freien Positionen durch Substituenten R1 substituiert sein können und M für Rh oder Ir steht.

Strukturelemente der Gruppe 5 sind solche, welche den Übergang vom sogenannten Singulett- zum Triplett-Zustand erleichtern, welche unterstützend zu den Strukturelementen der Gruppe 4 eingesetzt werden können und welche damit die Phosphoreszenzeigenschaften der Strukturelemente der Gruppe 4 verbessern. Hierfür kommen insbesondere Carbazoleinheiten, besonders bevorzugt überbrückte Carbazoldimereinheiten, in Frage, wie sie in den nicht offengelegten Anmeldungen DE 10304819.7 und DE 10328627.6 beschrieben werden.

Strukturelemente der Gruppe 6, die die Morphologie oder auch die Emissionsfarbe der Polymere beeinflussen, sind neben solchen gemäß Formel (lb) und Formeln (II) bis (LVI) des weiteren solche, welche mindestens noch eine weitere aromatische oder eine andere konjugierte Struktur aufweisen, welche nicht unter die o. g. Gruppen fällt, d. h. die die Ladungsträgermobilitäten nicht oder nur wenig beeinflußt bzw. keine metallorganischen Komplexe darstellt oder den Übergang vom Singulettzum Triplettzustand beeinflußt.

Bevorzugt sind dabei aromatische Strukturen, die 6 bis 40 C-Atome aufweisen oder auch Stilben-, Bisstyrylarylen- oder Tolanderivate, die jeweils mit einem oder mehreren nicht-aromatischen Resten R1 substituiert sein können.

Besonders bevorzugt ist dabei der Einbau von 1,4-Phenylen-, 1,4-Naphthylen-, 1,4-oder 9,10-Anthracenylen-, 1,6- oder 2,7- oder 4,9-Pyrenylen-, 3,9- oder 3,10-Perylenylen-, 2,7- oder 3,6-Phenanthrenylen-, 4,4'-Biphenylylen-, 4,4"-Terphenylylen-, 4,4'-Bi-1,1'-naphthylylen-, 4,4'-Stilben-, 4,4"-Bisstyrylarylen-oder 4,4'-Tolanderivaten.
Ganz besonders bevorzugt sind substituierte oder unsubstituierte Strukturen gemäß (LVII) - (LXVIII).

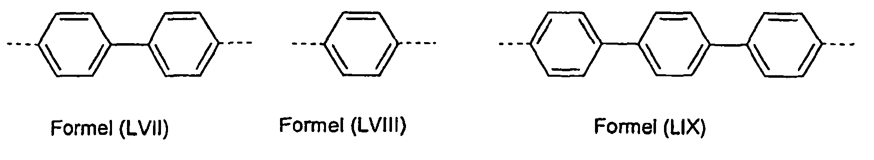

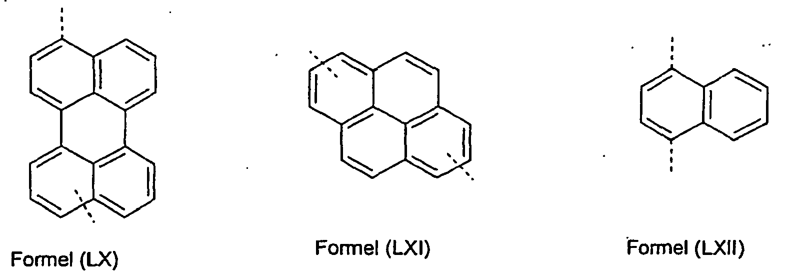

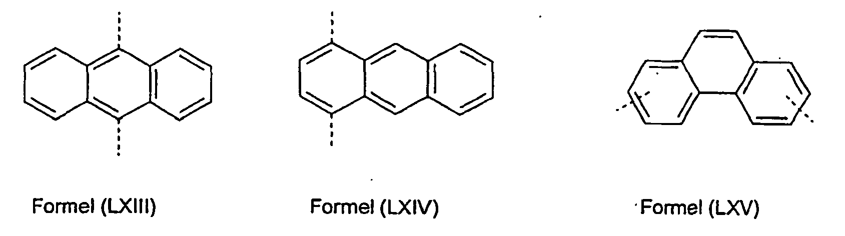

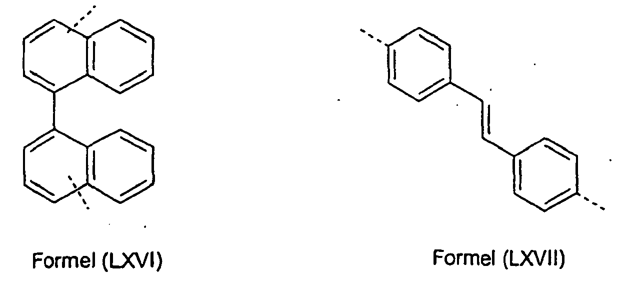

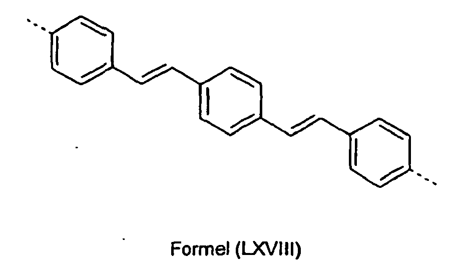

Strukturelemente der Gruppe 7 sind Einheiten, die aromatische Strukturen mit 6 bis 40 C-Atomen beeinhalten, welche typischerweise als Polymergrundgerüst (Backbone) verwendet werden. Dies wären beispielsweise 4,5-Dihydropyrenderivate, 4,5,9,10-Tetrahydropyrenderivate, Fluorenderivate, Spirobifluorenderivate, 5,7-Dihydrodibenzo-oxepinderivate und cis- und trans-Indenofluorenderivate. Bevorzugte Einheiten der Gruppe 7 sind dabei Einheiten gemäß den Formeln (LXIX) bis (LXXVIII), wobei die verschiedenen Positionen durch Substituenten R1 substituiert sein können,
- YY: Si oder Ge entspricht und
- VV: O, S, Se entspricht.

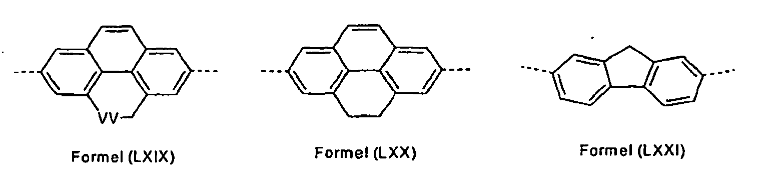

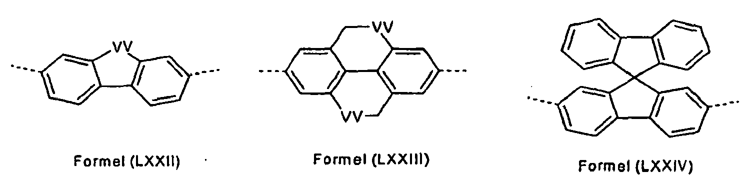

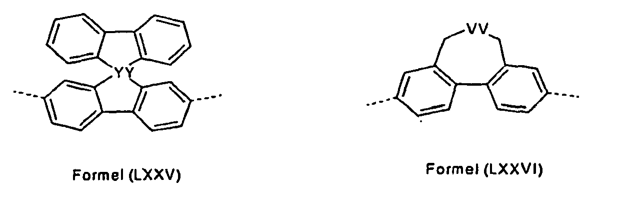

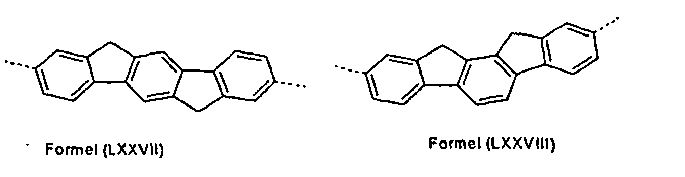

Bevorzugt sind dabei erfindungsgemäße Polymere, die gleichzeitig neben Struktureinheiten gemäß Formel (lb) zusätzlich noch eine oder mehrere Einheiten ausgewählt aus den Gruppen 1 bis 7 enthalten.

Des weiteren kann es ebenfalls bevorzugt sein, wenn gleichzeitig mehr als eine Struktureinheit aus einer Gruppe vorliegt. So kann es bevorzugt sein, wenn gleichzeitig mindestens zwei Struktureinheiten aus der Gruppe 1, bzw. Gruppe 2, bzw. Gruppe 3, bzw. Gruppe 4, bzw. Gruppe 5, bzw. Gruppe 6, bzw. Gruppe 7 vorliegen.

Die erfindungsgemäßen Polymere weisen in der Regel 10 bis 10000, bevorzugt 50 bis 5000, besonders bevorzugt 50 bis 2000 Wiederholeinheiten auf.

Die nötige Löslichkeit der Polymere wird v. a. durch die Substituenten R1 bis R4, sowohl an Einheiten gemäß Formel (lb) wie auch an anderen Wiederholeinheiten, gewährleistet. Falls Substituenten R5 und R6 vorhanden sind, tragen auch diese zur Löslichkeit bei.
Um ausreichende Löslichkeit zu gewährleisten, ist es bevorzugt, daß im Durchschnitt pro Wiederholeinheit mindestens 2 nicht-aromatische C-Atome in den Substituenten vorhanden sind. Bevorzugt sind dabei mindestens 4, besonders bevorzugt mindestens 8 C-Atome. Einzelne dieser C-Atome können auch durch O oder S ersetzt sein. Dies kann aber durchaus bedeuten, daß ein gewisser Anteil von Wiederholeinheiten, sowohl gemäß den Formeln (lb) bis (LXXVIII) als auch anderer Strukturtypen, keine weiteren nicht-aromatischen Substituenten trägt.
Um die Morphologie des Films nicht zu verschlechtern, ist es bevorzugt, keine langkettigen Substituenten mit mehr als 12 C-Atomen in einer linearen Kette zu haben, bevorzugt keine mit mehr als 8 C-Atomen, besonders bevorzugt keine mit mehr als 6 C-Atomen. Nicht-aromatische C-Atome sind, wie beispielsweise in der Beschreibung für R1 bis R4 in Formel (lb), in entsprechenden geradkettigen, verzweigten oder cyclischen Alkyl- oder Alkoxyketten enthalten.

Bevorzugt beträgt der Anteil der Einheiten gemäß Formel (lb) im Polymer mindestens 10 mol%, besonders bevorzugt mindestens 40 mol%. Dies gilt insbesondere, wenn diese Einheiten als Polymer-Grundgerüst (Backbone) verwendet werden. Werden diese Einheiten als emittierende Einheiten eingesetzt, so liegt ihr Anteil bevorzugt in der Größenordnung von 5 bis 20 mol%. Einheiten gemäß Formel (lb), die sich als emittierende Einheiten eignen, sind insbesondere solche, in denen mindestens ein Symbol a für 1 steht und das entsprechende Symbol b für 1 oder 2 steht.

Besonders bevorzugt sind weiterhin erfindungsgemäße Polymere, bei denen für Einheiten gemäß Formel (lb) gilt:
- R1-R4: ist bei jedem Auftreten gleich oder verschieden eine geradkettige oder verzweigte Alkyl- oder Alkoxykette mit 1 bis 8 C-Atomen oder eine Aryl- oder Aryloxygruppe mit 5 bis 14 C-Atomen, in welcher auch ein oder mehrere C-Atome durch N, S oder O ersetzt sein können und welche auch durch einen oder mehrere nicht-aromatische Reste R5 substituiert sind;
- b: ist bei jedem Auftreten gleich oder verschieden 0 oder 1;
die weiteren Symbole sind wie oben unter Formel (lb) definiert.

Ganz besonders bevorzugt sind des weiteren erfindungsgemäße Polymere, bei denen für Einheiten gemäß Formel (lb) gilt:
- R1, R3: sind bei jedem Auftreten gleich oder verschieden eine geradkettige oder verzweigte Alkylkette mit 1 bis 8 C-Atomen oder eine Arylgruppe mit 5 bis 10 C-Atomen, in welcher auch ein oder mehrere C-Atome durch N, S oder O substituiert sein können und welche auch durch einen oder mehrere nicht-aromatische Reste R5 substituiert sein können;
- R2, R4: sind bei jedem Auftreten gleich oder verschieden eine geradkettige oder verzweigte Alkoxykette mit 1 bis 8 C-Atomen;
- a: ist bei jedem Auftreten 1, falls die Einheiten gemäß Formel (lb) als Emitter verwendet werden;
- b: ist bei jedem Auftreten gleich 1, falls die Einheiten gemäß Formel (lb) als Emitter verwendet werden; ansonsten ist b bei jedem Auftreten gleich 0;
die weiteren Symbole sind wie oben unter Formel (lb) definiert.

Beispiele für besonders bevorzugte Strukturen gemäß Formel (lb) sind Strukturen gemäß Formel (LXXIX) bis (CVI), wobei die Verknüpfung im Polymer jeweils über die 2,7-Positionen der Dihydrophenanthreneinheiten erfolgt, wie durch die gestrichelten Bindungen angedeutet, und R für eine geradkettige oder verzweigte Alkylkette mit 1 bis 8 C-Atomen steht:

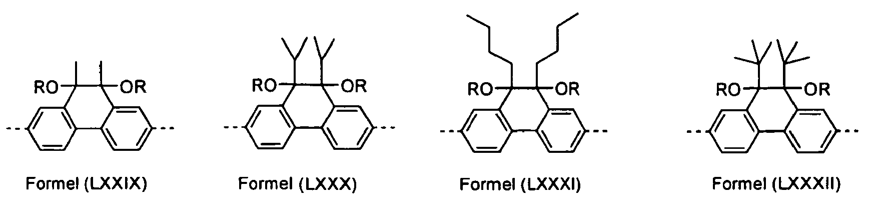

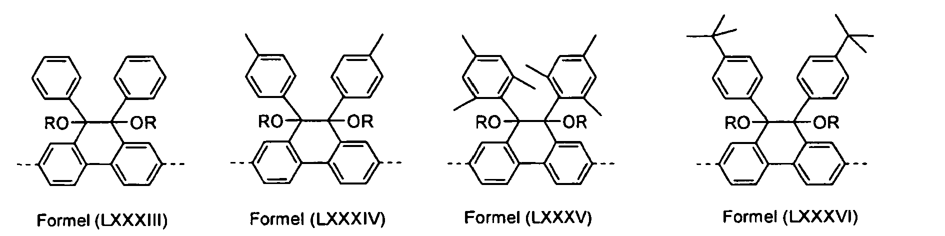

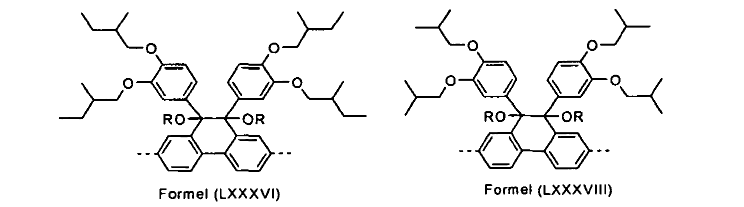

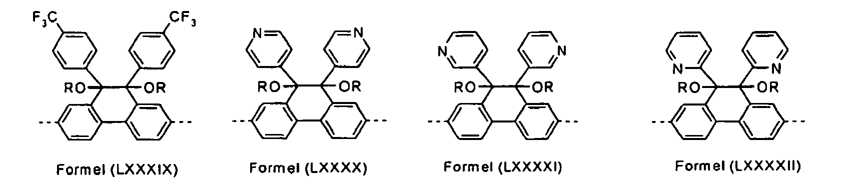

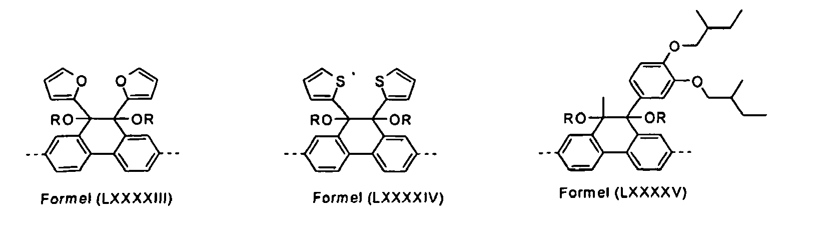

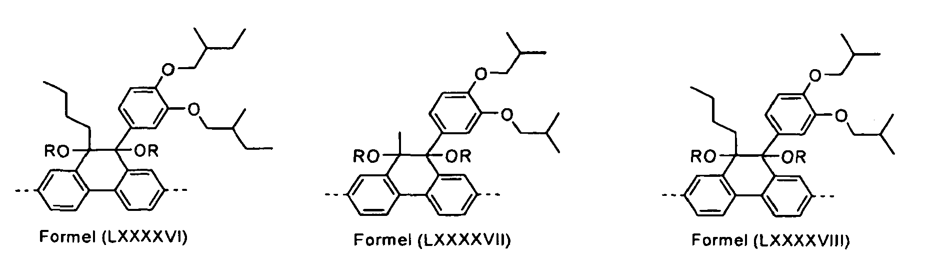

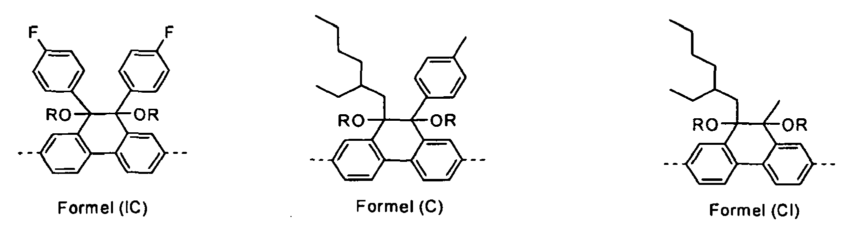

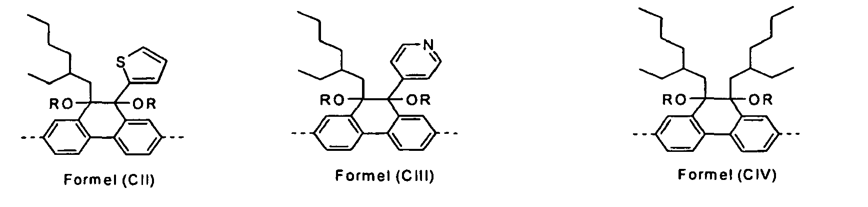

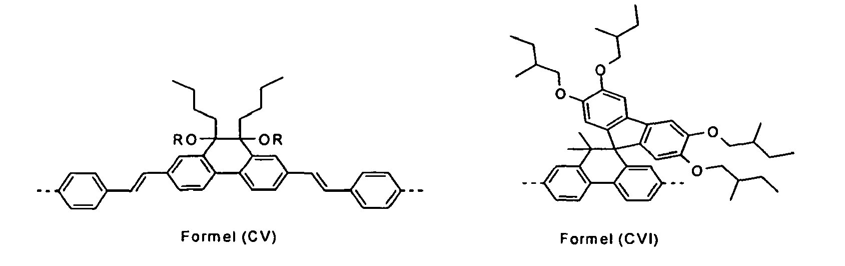

Die erfindungsgemäßen Polymere sind entweder Homopolymere oder Copolymere. Erfindungsgemäße Copolymere können dabei neben einer oder mehreren Strukturen gemäß Formel (lb), bzw. gemäß den Formeln (LXXIX) bis (CVI), potentiell eine oder mehrere weitere Strukturen, beispielsweise gemäß den Formeln (II) bis (LXXVI), besitzen.

Die erfindungsgemäßen Copolymere können statistische, alternierende oder blockartige Strukturen aufweisen oder auch mehrere dieser Strukturen abwechselnd besitzen. Wie Copolymere mit blockartigen Strukturen erhalten werden können und welche weiteren Strukturelemente dafür besonders bevorzugt sind, ist beispielsweise ausführlich beschrieben in der nicht offengelegten Anmeldung DE 10337077.3. Diese ist via Zitat Bestandteil der vorliegenden Anmeldung. Durch das Verwenden mehrerer verschiedener Strukturelemente können Eigenschaften wie Löslichkeit, Festphasenmorphologie, Farbe, Ladungsinjektions- und -transporteigenschaften, Temperaturstabilität, elektrooptische Charakteristik, etc. eingestellt werden.

Bevorzugt sind erfindungsgemäße Polymere, die außer Struktureinheiten gemäß Formel (lb) noch mindestens eine Struktureinheit gemäß den Formeln (II) bis (LXXVIII) enthalten. Wenn vorhanden, ist der Anteil dieser Strukturelemente dabei mindestens 1 mol%, bevorzugt mindestens 5 mol%. Der maximale Anteil dieser Strukturelemente ist dabei bevorzugt höchstens 90 mol%, besonders bevorzugt höchstens 60 mol%. Auch diese Struktureinheiten können im Polymer statistisch, alternierend oder blockartig eingebaut sein.

Die erfindungsgemäßen Polymere weisen gegenüber den in WO 03/020790 beschriebenen Poly-Spirobifluorenen und Polyfluorenen, beschrieben in WO 02/077060, die hiermit als nächstliegender Stand der Technik genannt werden, folgende Vorteile auf:
(1) Es wurde überraschend gefunden, daß die erfindungsgemäßen Polymere (bei ansonsten gleicher oder ähnlicher Struktur) höhere Leuchteffizienzen in der Anwendung aufweisen. Dies gilt besonders für die Copolymere, die blaue Emission zeigen, die ebenfalls in Bezug auf Farbort deutlich verbesserte Eigenschaften aufweisen. Dies ist von enormer Bedeutung, da somit entweder gleiche Helligkeit bei geringerem Energieverbrauch erzielt werden kann, was vor allem bei mobilen Applikationen (Displays für Handys, Pager, PDA, etc.), die auf Batterien und Akkus angewiesen sind, sehr wichtig ist. Umgekehrt erhält man bei gleichem Energieverbrauch höhere Helligkeiten, was beispielsweise für Beleuchtungsanwendungen interessant sein kann.
(2) Des weiteren hat sich überraschend gezeigt, daß wiederum im direkten Vergleich die erfindungsgemäßen Polymere höhere operative Lebensdauern aufweisen, insbesondere im Fall von grün und blau emittierenden PLEDs.
(3) Auch vom Löslichkeitsverhalten (z. B. Gelierungstemperatur bei gegebener Konzentration, Viskosität bei gegebener Konzentration) sind die erfindungsgemäßen Polymere den bekannten Polymeren gleichwertig bzw. weisen z. T. bessere Löslichkeit in einer größeren Bandbreite von Lösungsmitteln auf.
(4) Die Zugänglichkeit und die Erzielbarkeit von Farben ist bei den erfindungsgemäßen Polymeren gleichwertig zum Stand der Technik. Dies stellt somit zwar keinen unmittelbaren Vorteil dar, bedeutet jedoch, daß die erfindungsgemäßen Monomere ohne Abänderung weiterer Prozeßparameter bei der Polymerisation übernommen werden können, was keinesfalls erwartungsgemäß und damit überraschend ist.

Die Art des Einbaus der Strukturen gemäß Formel (II) bis (LXXVIII) ist bei etlichen schon direkt vorgegeben (siehe z. B. Formeln (II) bis (VI) und Formeln (XIV) bis (XX)). Bei anderen Strukturen sind jeweils mehrere Möglichkeiten erfindungsgemäß. Allerdings gibt es bei diesen auch bevorzugte Einbauweisen; darunter sollen die Einbauweisen verstanden werden, wie sie in WO 03/020790 beschrieben sind. Für die Synthese der oben aufgeführten Monomere (II) bis (LXVIII) sei hier auch nur auf die umfassende Beschreibung in WO 03/020790 verwiesen.

Monomere gemäß den Formeln (XXXIII) bis (XXXXVIII) lassen sich gemäß den für die Formeln (II) bis (XXXII) gemachten Angaben durch Kombination der entsprechenden Vorstufen synthetisieren, wie in WO 03/020790 ausgeführt. Die Herstellung von Monomeren aus der Gruppe 4, die statt Elektrofluoreszenz Elektrophosphoreszenz bewirken, ist in der o. g. Anmeldeschrift WO 02/068435 ausgeführt.

Für die Herstellung von Monomeren aus der Gruppe 5, die den Übergang vom Singulett- zum Triplett-Zustand erleichtern, sei an dieser Stelle auf die oben bereits zitierten Anmeldeschriften DE 10304819.7 und DE 10328627.6 verwiesen.

Die Herstellung von Monomeren gemäß den Formeln (LVII) bis (LXVIII), die die Morphologie oder auch die Emissionsfarbe der Polymere beeinflussen, ist in der Anmeldeschrift WO 03/020790 aufgeführt. Im Gegensatz zu den dortigen Angaben werden diese in die hier vorliegenden erfindungsgemäßen Polymere nur als zusätzliche Möglichkeiten, um weitere Modifikationen zu gestatten, eingeführt. Monomere gemäß den Formeln (LXIX) bis (LXXVI), die als Grundgerüst (Backbone) des resultierenden Polymers fungieren können, lassen sich, wie in den folgenden Stellen beschrieben, herstellen: Struktureinheiten gemäß Formel (LXIX) lassen sich beispielsweise gemäß Oae et al., Bull. Chem. Soc. Jpn. 1981, 54, 2374-78 herstellen. Monomere für den Einbau von Struktureinheiten gemäß Formel (LXX) lassen sich beispielsweise gemäß Blaschke et al., J. Am. Chem. soc. 1970, 92, 3675-81 herstellen. In der Anmeldeschrift WO 00/46321 wird, neben anderen Comonomeren, die Synthese von Monomeren des Typs (LXXI) beschrieben. Die Herstellung von Monomeren gemäß Formel (LXXII), worin VV = O entspricht, ist in Costero et al., J. Chem. Res. Miniprint 1994, 4, 761-769 beschrieben. Die Synthese von Monomeren gemäß Formel (LXXIII), worin VV = O entspricht, ist beispielsweise in Wang et al., Eur. J. Med. Chem. Chim. Ther. 1999, 34, 215-224 niedergelegt. Herstellungsverfahren für Monomere der Bauart gemäß Formel (LXXIV) sind beispielsweise in der Anmeldeschrift WO 03/020790 aufgeführt. Verbindungen des Typs (LXXV) mit YY = Si sind von Ballweg et al., Silicon Chemistry 2002, 1, 57-60 beschrieben, und die Synthese von Monomeren gemäß Formel (LXXVI) ist von Williams et al., J. Chem. Soc., Chem. Commun. 1996, 2259-2260 für VV = O beschrieben. Verbindungen des Typs (LXXVII) können beispielsweise synthetisiert werden, wie in WO 04/041901 beschrieben, Verbindungen des Typs (LXXVIII), wie in der nicht offengelegten Anmeldeschrift EP 03014042.0 beschrieben.

Monomere, die in erfindungsgemäßen Polymeren zu Struktureinheiten gemäß Formel (lb) führen, sind Dihydrophenanthrene, die an der 9,10-Position geeignet substituiert sind und an der 2,7-Position geeignete Funktionalitäten aufweisen, die es erlauben, diese Monomereinheiten in das Polymer einzubauen.

Die Literatur zur Synthese solcher Dihydrophenanthren-Verbindungen verweist auf einige Methoden, wie z. B. die Ni(COD)₂ vermittelte Kaskadenreaktion zwischen o-Bromacetophenonen (Scherf et al., J. Org. Chem. 1999, 64, 655-58), die zu Pinacolen führt. Solche Pinacole sind ebenfalls erhältlich durch zweifache Reaktion mit einem Grignard-Reagenz, einer Lithium-organischen Verbindung oder einer Zink-organischen Verbindung an Phenanthrenchinon. Dabei kann es bevorzugt sein, die Reaktion mit dem metallorganischen Mg-, Li- oder Zn-Reagenz zunächst am Phenanthrenchinon durchzuführen und erst zum Schluß Funktionalitäten einzuführen, die die Polymerisation erlauben, wie beispielsweise Bromfunktionalitäten. Es kann ebenfalls bevorzugt sein, zunächst das Phenanthrenchinon, beispielsweise durch Bromierung, zu funktionalisieren und danach die Reaktion mit dem metallorganischen Mg-, Li- oder Zn-Reagenz durchzuführen.

Die durch die Reaktion mit dem metallorganischen Mg-, Li- oder Zn-Reagenz entstandenen Pinacole können, um weitere löslichkeitsvermittelnde Substituenten einführen zu können, verethert werden. Weiterhin würde sich hier auch eine Esterfunktion anbieten, wie in der Literatur beschrieben (F. Uckert, Dissertation, Universität Mainz 1998). Dieser Ansatz, Carbonylfunktionen im Polymer zu generieren, wurde in dieser Erfindung allerdings wegen der unbekannten Folgereaktionspfade des zu erwartenden n→π* Übergangs (z. B. Norrish Typ 1 Spaltung) ausgeschlossen.

Unsymmetrische Dihydrophenanthren-Derivate sind beispielsweise erhältlich durch Reaktion eines Phenanthrenchinons mit einem Äquivalent eines metallorganischen Mg-, Li- oder Zn-Reagenzes, wie oben beschrieben, folgende Veretherung des entstandenen Alkohols und Umsatz mit einem weiteren Äquivalent eines anderen metallorganischen Mg-, Li- oder Zn-Reagenzes, wiederum gefolgt von Veretherung.

Der Weg der doppelten Reaktion mit einem metallorganischen Mg-, Li- oder Zn-Reagenz und anschließenden Alkylierung bietet die zweifache Möglichkeit der Einführung von löslichkeitsvermittelnden Substituenten und ermöglicht die Einführung weiterer Funktionalitäten an der richtigen Position innerhalb der Biarylachse (dirigierender Effekt). So kann beispielsweise durch Bromierung, beispielsweise mit elementarem Brom oder NBS, ein Dibromderivat erzeugt werden, das entweder direkt als Monomer in der Polymerisation eingesetzt werden kann oder durch Methoden, die dem Fachmann geläufig sind, beispielsweise in Boronsäurederivate oder Stannate umgesetzt werden kann, die dann ebenfalls in der Polymerisation eingesetzt werden können. Sonstige Synthesewege, wie z. B. photochemische Varianten (Bestrahlung von vinylsubstituierten Biphenylen) führen zu Dihydrophenanthrenen (Laarhoven et al., J. Chem. Soc. Perkin Trans. 2, 1978, 915-22), die noch benzylische Wasserstoffatome tragen, die im Diodenbetrieb erfahrungsgemäß zu verkürzten Lebensdauern führen und deshalb nicht bevorzugt sind.

Monomere, die im Polymer zu Einheiten gemäß Formel (lb) führen, sind bifunktionelle monomere Verbindungen gemäß Formel (CVII), 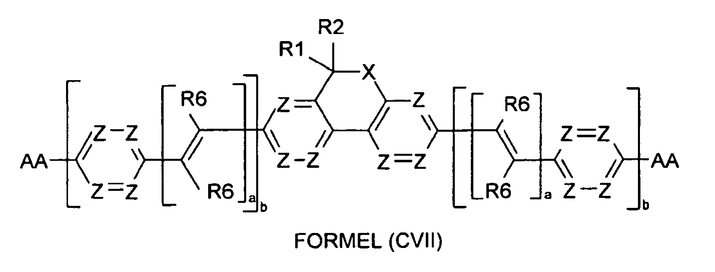 dadurch gekennzeichnet, daß die beiden funktionellen Gruppen AA, gleich oder verschieden, unter Bedingungen der C-C-Verknüpfungen copolymerisieren; X bei jedem Auftreten gleich oder verschieden C(R3)(R4) ist, Z bei jedem Auftreten gleich oder verschieden C(R5) ist, und die weiteren Symbole dieselbe Bedeutung wie in Formel (lb) haben.
Bevorzugt ist AA ausgesucht aus den Gruppen Cl, Br, I, O-Tosylat, O-Triflat, O-SO₂R5, B(OH)₂, B(OR5)₂ und Sn(R5)₃.

Die C-C-Verknüpfungen sind dabei bevorzugt ausgewählt aus den Gruppen der SUZUKI-Kupplung, der YAMAMOTO-Kupplung und der STILLE-Kupplung. Insbesondere bevorzugt sind hier monomere Verbindungen gemäß Formel (CVII), die nach Reaktion im Polymer zu Struktureinheiten gemäß Formel (LXXIX) bis (CVI) führen.

Ein Verfahren gemäß Formel (CVIII) zur Herstellung von symmetrischen, monomeren bifunktionellen Verbindungen gemäß Formel (CVII), bzw. ein Verfahren gemäß Formel (CIX) zur Herstellung von unsymmetrischen, monomeren bifunktionellen Verbindungen gemäß Formel (CVII), wobei X für C(R3)(R4) und Z für C(R5) steht, außerdem R1 und R3 eine Alkyl- oder Arylgruppe und R2 und R4 eine Alkoxygruppe darstellen, ist dadurch gekennzeichnet, dass ein Phenanthrenchinon umgesetzt wird mit einer Magnesium-organischen bzw. Lithium-organischen bzw. Zink-organischen Verbindung, gefolgt von Reaktion mit einem Alkylierungsreagenz R-LG unter basischen Bedingungen: 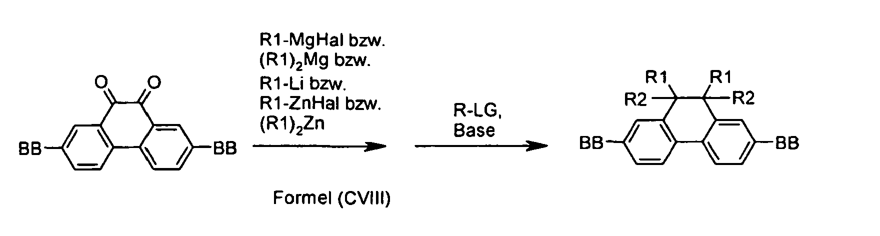 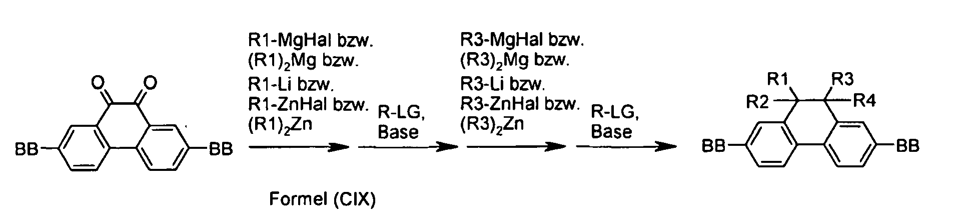 wobei für die verwendeten Symbole gilt:
- BB: ist bei jedem Auftreten gleich oder verschieden H oder hat dieselbe Bedeutung, wie oben für AA beschrieben;
- R-LG: ist bei jedem Auftreten gleich oder verschieden ein Alkylierungsreagenz, wobei R für eine Alkylgruppe steht, bevorzugt eine lineare oder verzweigte Alkylkette mit 1 bis 8 C-Atomen, und LG eine Gruppe, die unter den Bedingungen der nukleophilen aliphatischen Substitution als Abgangsgruppe reagiert, bevorzugt Cl, Br, I, O-Tosylat oder O-Triflat;
- R1, R3: steht für eine Alkyl-, Aryl- oder Heteroarylgruppe;
- R2, R4: steht für eine Alkoxygruppe O-R, wobei R dieselbe Bedeutung hat, wie oben beschrieben;
- Hal: steht für F, Cl, Br, I.

Der Vorgang der Addition des metallorganischen Mg-, Li- bzw. Zn-Reagenzes, gefolgt von der Umsetzung mit einem Alkylierungsreagenz wird dabei für die Synthese der unsymmetrischen monomeren Verbindung zweimal nacheinander durchgeführt.

Unter Magnesium-organischen Verbindungen werden Verbindungen verstanden, die mindestens eine Mg-C Bindung aufweisen, wobei neben R₂Mg auch R-Mg-Halogenid (R = Alkyl, Aryl) als sogenannte Grignard-Verbindungen bevorzugt werden. Unter Lithium-organischen Verbindungen werden Verbindungen verstanden, die mindestens eine Li-C Bindung aufweisen, im einfachsten Fall R-Li, z. B. Phenyllithium, Butyllithium, Methyllithium, wobei kovalente Mehrzentrenbindungen ausdrücklich zugelassen sind. Unter Zink-organischen Verbindungen werden Verbindungen verstanden, die mindestens eine Zn-C Bindung aufweisen, wobei Verbindungen der allgemeinen Formeln R₂Zn und R-Zn-Halogenid (R = Alkyl, Aryl) bevorzugt sind.

Als Base für die Veretherung eignen sich bevorzugt Metallhydride, wie z. B. Natriumhydrid, Metallcarbonate, wie z. B. Natriumcarbonat oder Kaliumcarbonat, oder Metallalkoholate, wie z. B. Natriummethanolat, Natriumethanolat oder Kaliumtert-butanolat.

In einer bevorzugten Ausführungsform des Verfahrens gemäß Formel (CVIII) bzw. (CIX) wird als metallorganisches Reagenz eine Grignardverbindung verwendet.

Die erfindungsgemäßen Polymere werden in der Regel durch Polymerisation von einer oder mehreren Monomersorten hergestellt, von denen mindestens eines durch die Formel (lb) und, wenn vorhanden, weitere durch die Formeln (II) bis (LXXVIII) beschrieben sind. Entsprechende Polymerisationsreaktionen gibt es prinzipiell viele. Es haben sich hier jedoch einige Typen besonders bewährt, die alle zu C-C-Verknüpfungen führen:
(A) Polymerisation gemäß SUZUKI
(B) Polymerisation gemäß YAMAMOTO
(C) Polymerisation gemäß STILLE.

Wie die Polymerisation nach diesen Methoden durchgeführt werden kann und wie die Polymere dann vom Reaktionsmedium abgetrennt und aufgereinigt werden können, ist beispielsweise im Detail beschrieben in WO 03/048225 und WO 04/022626.

Es kann außerdem bevorzugt sein, das erfindungsgemäße Polymer nicht als Reinsubstanz, sondern als Mischung (Blend) zusammen mit weiteren beliebigen polymeren, oligomeren, dendritischen oder niedermolekularen Substanzen zu verwenden. Diese können beispielsweise die elektronischen Eigenschaften verbessern, den Transfer vom Singulett- zum Triplettzustand beeinflussen oder selber emittieren. Aber auch elektronisch inaktive Substanzen können sinnvoll sein, um beispielsweise die Morphologie des gebildeten Polymerfilms oder die Viskosität von Polymerlösungen zu beeinflussen. Solche Blends sind daher auch Bestandteil der vorliegenden Erfindung.

Gegenstand der Erfindung sind weiterhin Lösungen und Formulierungen aus einem oder mehreren erfindungsgemäßen Polymeren oder Blends in einem oder mehreren Lösungsmitteln. Wie Polymerlösungen hergestellt werden können, ist beispielsweise in WO 02/072714, in WO 03/019694 und in der darin zitierten Literatur beschrieben. Diese Lösungen können dann verwendet werden, um dünne Polymerschichten herzustellen, zum Beispiel durch Flächenbeschichtungsverfahren (z. B. Spincoating) oder durch Druckverfahren (z. B. InkJet Printing).

Die erfindungsgemäßen Polymere können nun in PLEDs verwendet werden. Wie PLEDs hergestellt werden können, wird als allgemeines Verfahren ausführlich in WO 04/037887 beschrieben, das entsprechend für den Einzelfall anzupassen ist. Wie oben beschrieben, eignen sich die erfindungsgemäßen Polymere ganz besonders als Elektrolumineszenzmaterialien in den derart hergestellten PLEDs oder Displays.

Als Elektrolumineszenzmaterialien im Sinne der Erfindung gelten Materialien, die als aktive Schicht in einer PLED Verwendung finden können. Aktive Schicht bedeutet, daß die Schicht befähigt ist, bei Anlegen eines elektrischen Feldes Licht abzustrahlen (lichtemittierende Schicht) und/oder daß sie die Injektion und/oder den Transport der positiven und/oder negativen Ladungen verbessert (Ladungsinjektions- oder Ladungstransportschicht).

Gegenstand der Erfindung ist daher auch die Verwendung eines erfindungsgemäßen Polymers in einer PLED, insbesondere als Elektrolumineszenzmaterial.

Gegenstand der Erfindung ist somit ebenfalls eine PLED mit einer oder mehreren aktiven Schichten, wobei mindestens eine dieser aktiven Schichten ein oder mehrere erfindungsgemäße Polymere enthält. Die aktive Schicht kann beispielsweise eine lichtemittierende Schicht und/oder eine Ladungstransportschicht und/oder eine Ladungsinjektionsschicht sein.

Im vorliegenden Anmeldetext und auch in den im weiteren folgenden Beispielen wird auf die Verwendung erfindungsgemäßer Polymere oder Blends in Bezug auf PLEDs und die entsprechenden Displays abgezielt. Trotz dieser Beschränkung der Beschreibung ist es für den Fachmann ohne weiteres erfinderisches Zutun möglich, die erfindungsgemäßen Polymere auch für weitere Verwendungen in anderen elektronischen Devices (Vorrichtungen) zu benutzen, z. B. für organische integrierte Schaltungen (O-ICs), in organischen Feld-Effekt-Transistoren (OFETs), in organischen Dünnfilmtransistoren (OTFTs), für organische Solarzellen (O-SCs), für organische Photorezeptoren oder auch organische Laserdioden (O-Laser), um nur einige Anwendungen zu nennen.
Die Verwendung erfindungsgemäßer Polymere in den entsprechenden Vorrichtungen ebenso wie diese Vorrichtungen selbst sind ebenfalls Gegenstand der vorliegenden Erfindung.

### Beispiele

### Teil A: Synthese der erfindungsgemäßen Monomere für Einheiten gemäß Formel (lb) (Dihydrophenanthren (= DHP)-Einheiten)

### A 1 Synthese symmetrischer DHP-Monomere

### A 1.1 Synthese von 2,7-substituierten 9,10-Dibutyl-9,10-dimethoxy-9,10-dihydrophenanthrenen

### A 1.1.1 Synthese von 9,10-Dibutyl-9,10-dihydrophenanthren-9,10-diol

Zu einer Lösung von 41.75 g (0.2 mol) Phenanthrenchinon in 800 mL trockenem THF wurden bei einer Innentemperatur von 10 °C 300 mL einer 2.0 M Lösung von n-Butylmagnesiumchlorid (0.6 mol) innerhalb 1.5 h zugetropft und anschließend bei RT für 6 h gerührt. Nach Hydrolyse mit 125 mL ges. NH₄Cl Lösung wurde der Niederschlag abgesaugt, mit Ethylacetat gewaschen, das Filtrat zweimal mit Wasser extrahiert und die organischen Phase über Na₂SO₄ getrocknet. Der nach Abdampfen des Lösungsmittels verbliebene braune Feststoff wurde anschließend zweimal aus EtOH/H₂O (70:30) umkristallisiert. Man erhielt 60.6 g (93%) farbloser Nadeln.
¹H-NMR (CDCl₃): [ppm] = 7.68 (dd, ³J_{HH} = 6.7 Hz, ⁴J_{HH} = 1.7 Hz, 2 H), 7.55 (dd, ³J_{HH} = 6.4 Hz, ⁴J_{HH} = 1.7 Hz, 2 H), 7.33 (m, 4 H), 2.04 (s, mit D₂O austauschbar, 2 H, OH), 1.75 (m, 2 H, alkyl), 1.44 (m, 2 H, alkyl), 1.32 (m, 2 H, alkyl), 1.1 (m, 2 H, alkyl), 1.00 (m, 2 H, alkyl), 0.77 (m, 2 H, alkyl), 0.73 (t, ³J_{HH} = 7.4 Hz, 6 H, alkyl).

### A 1.1.2 Synthese von 9,10-Dibutyl-9,10-dimethoxy-9,10-dihydrophenanthren

Zu einer Suspension von 10 g NaH (60% in Mineralöl, 250 mmol) in 80 mL trockenem DMSO wurden innerhalb 30 min 26.6 g des oben hergestellten Diols in 80 mL trockenem DMSO bei ca. 15 °C Innentemperatur zugetropft, die Mischung für weitere 30 min bei RT gerührt und anschließend 16 mL Mel (250 mmol) innerhalb 1 h zugespritzt und die Lösung weitere 2 h gerührt. Anschließend wurden 80 mL 15% NH₄OH zugetropft, das Reaktionsgemisch zweimal mit Ethylacetat extrahiert und die vereinigten org. Phasen dreimal mit Wasser gewaschen und über Na₂SO₄ getrocknet. Nach Entfernen des Lösungsmittels im Vakuum erhielt man ein beiges Öl, das laut RP-HPLC einen Reinheitsgrad von 99.0% aufwies und ohne weitere Reinigung in die Folgereaktion eingesetzt wurde.
¹H-NMR (CDCl₃): [ppm] = 7.64 (dd, ³J_{HH} = 7.4 Hz, ⁴J_{HH} = 2.3 Hz, 2 H), 7.51 (dd, ³J_{HH} = 6.7 Hz, ⁴J_{HH} = 2.3 Hz, 2 H), 7.28 (m, 4 H), 3.70 (s, 6 H, OMe), 2.13 (m, 2 H, alkyl), 1.52 (m, 2 H, alkyl), 1.16 (m, 2 H, alkyl), 1.08 (m, 2 H, alkyl), 0.97 (m, 2 H, alkyl), 0.88 (m, 2 H, alkyl) 0.67 (t, ³J_{HH} = 7.4 Hz, 6 H, alkyl).

### A 1.1.3. Synthese von 2,7-Dibrom-9,10-dibutyl-9,10-dimethoxy-9,10-dihydrophenanthren (EM1)

28.9 g (82 mmol) 9,10-Dibutyl-9,10-dimethoxy-9,10-dihydrophenanthren wurden in 190 mL trockenem DMF gelöst, unter Eiskühlung tropfenweise über einen Zeitraum von 1 h mit 17 mL Brom (0.33 mol) versetzt und anschließend bei RT für 48 h gerührt. Nach dieser Zeit gab man 125 mL gesättigte Na₂SO₃-Lsg zu und extrahierte den Ansatz zweimal mit CH₂Cl₂, reextrahierte die vereinigten organischen Phasen dreimal mit ges. NaHCO₃-Lsg. und trocknete über Na₂SO₄. Der nach Entfernen des Lösungsmittels verbliebene gelbe Feststoff wurde dreimal aus MeOH/*i*-PrOH umkristallisiert. Es verblieben 17.6 g (42%) farbloser Kristalle, die laut RP-HPLC einen Gehalt >99.98% aufwiesen.
¹H-NMR (CDCl₃): [ppm] = 7.65 (d, ⁴J_{HH} = 1.7 Hz, 2 H), 7.43 (m, 4 H), 3.67 (s, 6 H, OMe), 2.11 (m, 2 H, alkyl), 1.44 (m, 2 H, alkyl), 1.10 (m, 6 H, alkyl), 0.67 (t, ³J_{HH} = 7.4 Hz, 6 H, alkyl), 0.59 (m, 2 H, alkyl). Die 2,7-Stellung der Bromatome wurde durch NOE-Spektroskopie belegt.

### A 1.1.4. Synthese von 9,10-Dibutyl-9,10-dimethoxy-9,10-dihydrophenanthren-2,7-bis-(boronsäureethylenglycolester) (EM2)

Eine Grignardlösung, hergestellt aus 4.9 g Mg (203 mmol), 100 mg lod (0.4 mmol), 0.75 mL Dichlorethan (9.5 mmol) und 49.3 g 2,7-Dibrom-9,10-dibutyl-9,10-dimethoxy-9,10-dihydrophenanthren (96.6 mmol) in 270 mL THF, wurde bei -75°C zu einer Lösung von 30.1 g B(OMe)₃ (590 mmol) in 125 mL THF innerhalb 2 h zugetropft. Man ließ innerhalb 6 h auf 0 °C erwärmen, wonach die Viskosität der Suspension stark angestiegen war. Die Suspension wurde mit 100 mL Ethylacetat verdünnt, 15 mL Eisessig sowie 35 mL H₂O zugegeben, die org. Phase abgetrennt, zweimal mit 1 M HCl gewaschen und über Na₂SO₄ getrocknet. Der nach Entfernen des Lösungsmittels im Vakuum verbliebene Sirup wurde in 175 mL trockenem Toluol suspendiert und nach Zugabe von 10.8 mL Ethylenglycol (193 mmol) am Wasserabscheider zum Sieden erhitzt. Die nunmehr klare Lösung wurde im Vakuum eingeengt und der feste Rückstand einmal aus Ethylacetat sowie dreimal aus Toluol/Heptan umkristallisiert. Es verblieben 32 g (66%) des Bisboronsäureesters als farblose Kristalle mit einer durch RP-HPLC bestimmten Reinheit von 99.97%. ¹H-NMR (CDCl₃): [ppm] = 7.96 (s, 2 H), 7.75 (d, ³J_{HH} = 7.7 Hz, 2 H), 7.69 (d, ³J_{HH} = 7.7 Hz, 2 H), 4.39 (s, 8 H, Ethylen), 3.70 (s, 6 H, OMe), 2.12 (m, 2 H, alkyl), 1.48 (m, 2 H, alkyl), 1.17 (m, 2 H, alkyl), 1.03 (m, 2 H, alkyl), 0.94 (m, 2 H, alkyl), 0.65 (t, ³J_{HH} = 7.4 Hz, 6 H, alkyl), 0.57 (m, 2 H, alkyl).

### A 1.2 Synthese von 2,7-substituierten 9,10-(4-tert-Butylphenyl)-9,10-dimethoxy-9,10-dihydrophenanthrenen

### A 1.2.1 Synthese von 2,7-Dibromphenanthrenchinon

62.5 g Phenanthrenchinon (300 mmol) wurden in 750 mL konz. H₂SO₄ gelöst und bei RT mit 106.8 g NBS (600 mmol) versetzt. Nach 30 min intensivem Rührens wurde der dunkle Brei in 2 L Eiswasser gegossen, der hellrote Niederschlag abgesaugt, mit Wasser gewaschen und in EtOH (500 mL) ausgerührt. Nach erneutem Absaugen und Auskochen in CH₂Cl₂ erhielt man das Dibromid (85 g, 77%) in ausreichender Reinheit für weitere Umsetzungen (ca. 98% It. ¹H-NMR).
¹H-NMR (d₆-DMSO): [ppm] = 8.21 (d, ³J_{HH} = 8.7 Hz, 2 H), 8.08 (d, ⁴J_{HH} = 2.3 Hz, 2 H), 7.95 (dd, ³J_{HH} = 8.4 Hz, ⁴J_{HH} = 2.0 Hz, 2 H).

### A 1.2.2 Synthese von 2,7-Dibrom-9,10-bis-(t-butylphenyl)-9,10-dihydroxy-9,10-dihydrophenanthren

Zu einer Suspension von 75.5 g Dibromphenanthrenchinon (207 mmol) in 500 mL trockenem THF wurde das Grignardreagenz, hergestellt aus 132.2 g 4*-tert-*Butylbrombenzol (621 mmol) und 15.1 g Mg (621 mmol) in 620 mL trockenem THF, bei 0 °C Innentemperatur innerhalb 30 min zugetropft. Die resultierende grüne Lösung wurde 1 h bei RT gerührt und dann mit 200 mL gesättigter NH₄Cl-Lösung versetzt, vom entstandenen Niederschlag abgesaugt, dieser mit Ethylacetat gewaschen und das Filtrat zweimal mit Wasser extrahiert. Die vereinigten org. Phasen wurden über Na₂SO₄ getrocknet, vom Lösungsmittel befreit und der verbliebene Feststoff in MeOH ausgekocht. Man erhielt 86.6 g (66%) des Diols als farblosen Feststoff.
¹H-NMR (CDCl₃): [ppm] = 7.73 (d, ³J_{HH}= 8.4 Hz, 2 H), 7.66 (d, ⁴J_{HH}= 2.3 Hz, 2 H), 7.53 (dd, ³J_{HH} = 8.4 Hz, ⁴J_{HH} = 2.0 Hz, 2 H), 7.27 (m, 4 H), 7.22 (m, 4 H), 2.23 (s, mit D₂O austauschbar, 2 H, O-H), 1.24 (s, 18 H, *t-*Bu).

### A 1.2.3 Synthese von 2,7-Dibrom-9,10-bis-(t-butylphenyl)-9,10-dimethoxy-9,10-dihydrophenanthren (EM3)

Zu einer Suspension von 13.1 g NaH (60% Dispersion in Mineralöl, 328 mmol) in 180 mL.trockenem DMSO gab man bei RT in kleinen Portionen 69.3 g des oben hergestellten Dihydrophenanthrendiols zu und rührte die dunkle Lösung für 30 min bei RT. Anschließend tropfte man 20.4 mL Mel (328 mmol) zu, wobei sich ein farbloser Feststoff bildete. Nach 3 h wurden 180 mL 15% NH₄OPH sowie 100 mL MeOH zugetropft, der Kristallbrei abgesaugt und mit Wasser und EtOH gewaschen. Nach dreimaliger Umkristallisation aus EtOH/Toluol erhielt man 47 g (65%) des Bisethers mit einer Reinheit von >99.90% (RP-HPLC).
¹H-NMR (CDCl₃): [ppm] = 7.77 (d, ³J_{HH} = 8.3 Hz, 2 H), 7.58 (dd, ³J_{HH} = 8.4 Hz, ⁴J_{HH} = 2.0 Hz, 2 H), 7.48 (d, ⁴J_{HH} = 2.0 Hz, 2 H), 7.31 *(br,* d, ³J_{HH} = 8.0 Hz, 2 H), 7.27 *(br,* d, ³J_{HH} = 7.9 Hz, 2 H), 6.74 (*br*, d, ³J_{HH} = 8.0 Hz, 2 H), 6.25 (*br*, d, ³J_{HH} = 8.1 Hz, 2 H), 2.77 (s, 6 H, O-Me), 1.29 (s, 18 H, *t-*Bu). Die 2,7-Stellung der Bromatome wurde durch NOE-Spektroskopie belegt

### A 1.2.4 Synthese von 9,10-Bis-(t-butylphenyl)-9,10-dimethoxy-9,10-dihydrophenanthren-2,7-bis-(boronsäureethlenglycolester) (EM4)

Zu einer Lösung bestehend aus 11.1 g B(OMe)₃ in 50 mL trockenem THF wurde ein Grignard Reagenz, hergestellt aus 23.6 g des oben genannten DHP-Dibromids (35.6 mmol) und 1.8 g Mg in 100 mL trockenem THF, bei -60 °C innerhalb von 4 h getropft. Nach Erwärmen auf RT wurde das zähe RG mit 10 mL Eisessig und 50 mL Wasser verdünnt und dreimal mit Ethylacetat extrahiert. Die vereinigten org. Phasen wurden zweimal mit gesättigter NaCl-Lösung gewaschen und über Na₂SO₄ getrocknet. Der nach Entfernen des Lösungsmittels im Vakuum verbliebene farblose Schaum wurde in 100 mL Toluol suspendiert und nach Zugabe von 4 mL Ethylenglycol (71.2 mmol) bis zur konstanten Wasserabgabe zum Sieden erhitzt. Anschließend destillierte man das Lösungsmittel ab und kristallisierte den verbliebenen Feststoff viermal aus Ethylacetat um. Man erhielt 17 g (74%) des Bisboronsäureesters als farblose Kristalle mit einer Reinheit von >99.90% (RP-HPLC).
¹H-NMR (CDCl₃): [ppm] = 7.99 (d, ³J_{HH} = 7.7 Hz, 2 H), 7.92 (dd, ³J_{HH} = 7.7 Hz, ⁴J_{HH} = 1.3 Hz, 2 H), 7.78 (d, ⁴J_{HH}= 1.3 Hz, 2 H), 7.36 *(br,* d, ³J_{HH}= 8.0 Hz, 2 H), 7.22 *(br,* d, ³J_{HH} = 6.8 Hz, 2 H), 6.72 *(br,* d, ³J_{HH} = 7.7 Hz, 2 H), 6.24 (*br*, d, ³J_{HH} = 6.7 Hz, 2 H), 4.33 (m, 8 H, Ethylen), 2.73 (s, 6 H, O-Me), 1.29 (s, 18 H, *t-*Bu).

### A 2 Synthese von Spiro-DHP-Monomeren

### A 2.1 Herstellung von Spiro-[9H-2,3,6,7-tetrakis-(2-methylbutyloxy)-fluorene-9,9'(10'H)-10_{',}10'-dimethyl-2,7-dibrom-phenanthrene] (EM5)

In einer trockenen Apparatur wurden aus 5.3 g Mg (216.3 mmol) und 108.3 g (187.4 mmol) 2-Bromo-4,5,3',4'-tetrakis-(2-methylbutoxy)-biphenyl in 250 mL trockenem THF das Grignard-Reagenz hergestellt und anschließend zur Lösung von 2,7-Dibromo-10,10-dimethyl-10H-phenanthren-9-on (54.8 g, 144.2 mmol) in 220 mL THF bei RT getropft. Das Gemisch wurde 4 h unter Rückfluß erhitzt. Zur Aufarbeitung wurde in 50 mL HCl in 500 mL Eiswasser eingerührt, mit Ethylacetat extrahiert, über Na₂SO₄ getrocknet und im Vakuum vom Lösungsmittel befreit. Der Rückstand wurde in 500 mL Eisessig sowie 10 mL konz. HCl suspendiert und 4 h unter Rückfluß erhitzt. Der entstandene Niederschlag wurde abgesaugt, mit Eisessig, Wasser und MeOH gewaschen und viermal aus i-PrOH umkristallisiert. Man erhielt 56 g (45%) farbloser Kristalle mit einer durch RP-HPLC ermittelten Reinheit von 99.80%.
¹H-NMR (CDCl₃): [ppm] = 7.72 (d, ³J_{HH} = 8.4 Hz, 1 H), 7.69 (d, ³J_{HH} = 8.4 Hz, 1 H), 7.50 (dd, ³J_{HH} = 8.4 Hz, ⁴J_{HH} = 2 Hz, 1 H), 7.44 (dd, ³J_{HH} = 8.4 Hz, ⁴J_{HH} = 2 Hz, 1 H), 7.39 (d, ⁴J_{HH} = 1.7 Hz, 1 H), 7.16 (*br*, s, 1 H), 7.00 (*br*, s, 1 H), 6.94 *(br,* s, 1 H), 7.00 *(br,* s, 1 H), 6.90 (d, ⁴J_{HH} = 1.7 Hz, 1 H), 5.74 *(br,* s, 1 H), 3.82 (m, 6 H), 3.12 (m, 2 H), 0.5-2.1 (m, 42 H).

### A 3 Synthese unsymmetrischer DHP-Monomere

### A 3.1 Herstellung von 2,7-Dibromo-9,10-dimethoxy-9-methyl-10-p-tolyl-9,10-dihydro-phenanthren (EM6)

In einer trockenen Apparatur wurden 4.52 g (113 mmol) NaH als 60%ige Dispersion in Mineralöl vorgelegt, 40 mL trockenes DMSO zugegeben, anschließend 36.8 g (75.4 mmol) 2,7-Dibromo-10-methoxy-10-methyl-9-p-tolyl-9,10-dihydrophenanthren-9-ol in 100 mL trockenem DMSO zugetropft und bei RT 30 min gerührt. Dann wurden unter Eiskühlung 7 mL (113 mmol) Mel innerhalb 1 h zugetropft und 1 h bei RT gerührt. Zur Aufarbeitung wurde auf 5 °C abgekühlt, 150 mL 15% NH₄OH zugetropft, der Niederschlag abgesaugt, zweimal mit Wasser und zweimal mit MeOH gewaschen. Zur weiteren Reinigung wurde viermal aus EtOH/Toluol umkristallisiert. Es verblieben 16.7 g (44%) farbloser Kristalle mit einer durch RP-HPLC bestimmten Reinheit von 99.90%.
¹H-NMR (CDCl₃): [ppm] = 7.67 (d, ³J_{HH} = 8.4 Hz, 1 H), 7.63 (d, ³J_{HH} = 8.4 Hz, 1 H), 7.57 (d, ⁴J_{HH} = 2.0 Hz , 1 H), 7.53 (m, 2 H), 7.37 *(br,* s, 2 H), 7.28 (d, ⁴J_{HH} = 2.0 Hz), 7.22 *(br,* s, 2 H), 2.82 (s, 3 H), 2.79 (s, 3 H), 2.42 (s, 3 H), 1.24 (s, 3 H).

### A 4 Synthese von DHP-OPV-Monomeren

### A 4.1 Herstellung von 2,7-Bis-[2-(4-bromophenyl)-vinyl]-9,10-dibutyl-9,10-dimethoxy-9,10-dihydro-phenanthren (EM7)

22.9 g (74.7 mmol) 4-Bromobenzyl-phosphonsäurediethylester wurden in 200 mL DMF gelöst und unter Schutzgas bei ca. 5°C mit 14.4 g (149 mmol) NaO^{t}Bu versetzt. Nach 30 min Rührzeit bei 5 °C wurden 13.9 g (34 mmol) 9,10-Dibutyl-9,10-dimethoxy-9,10-dihydrophenanthren-2,7-dicarbaldehyd bei max. 5 °C innerhalb 15 min. zugegeben und anschließend 1 h bei 5 °C gerührt. Zur Aufarbeitung wurden 50 mL 4M HCl zugetropft, der entstandene Niederschlag abgesaugt, mit Wasser und MeOH gewaschen und getrocknet. Anschließende dreimalige Umkristallisation aus EtOH/Toluol lieferte 21.1 g (87%) des Monomers mit einer durch RP-HPLC bestimmten Reinheit von 99.8%.
¹H-NMR (CDCl₃): [ppm] = 7.65 (m, 4 H), 7.47 (m, 6 H), 7.41 (d, ³J_{HH} = 8.7 Hz 4 H), 7.14 (d, ³J_{HH} = 16.4 Hz, 2 H), 7.11 (d, ³J_{HH} = 16.1 Hz, 2 H), 3.76 (s, 6 H), 2.17 (m, 2 H), 1.55 (m, 2 H), 1.18 (m, 6 H), 0.68 (m, 8 H).

### Teil B: Synthese von Polymeren enthaltend Dihydrophenanthreneinheiten

Die Strukturen der beschriebenen erfindungsgemäßen Monomere **(EM)** und weiterer Monomere **(M)** für erfindungsgemäße Polymere **(P)** und Vergleichspolymere **(V)** sind im folgenden abgebildet. Die Synthese dieser Verbindungen ist oben und in WO 03/020790 niedergelegt. 9,10-Dibromanthracen wurde käuflich erworben (Aldrich, 98 %) und durch Umkristallisation aus Dioxan weiter aufgereinigt.

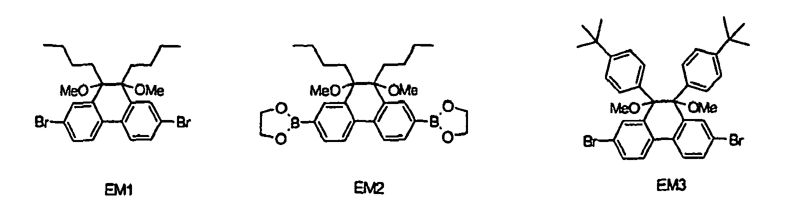

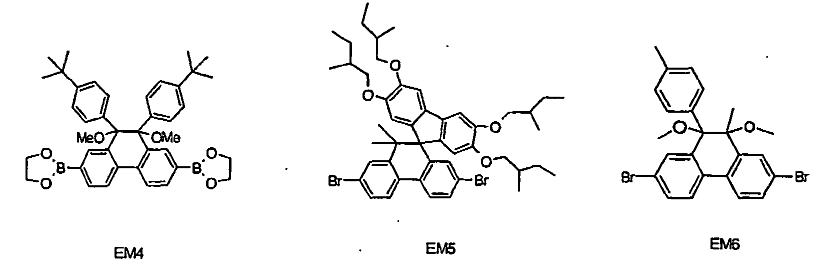

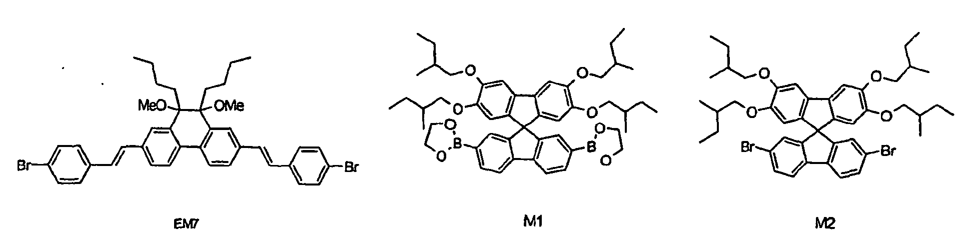

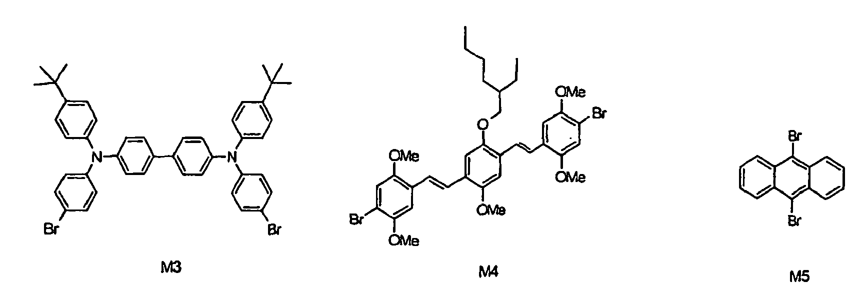

### B1: Synthese von Polymer P3

Copolymerisation von 50 mol% 9,10-Bis-(*t-*butylphenyl)-9,10-dimethoxy-9,10-dihydro-phenanthren-2,7-bis-(boronsäureethlenglycolester) (**EM4)**, 20 mol% von 2,7-Dibrom-9,10-bis-(*t-*butylphenyl)-9,10-dimethoxy-9,10-dihydro-phenanthren **(EM3)**, 10 mol% N,N'-Bis-(4-bromophenyl)-N,N'-bis-(4-tert-butylphenyl)-benzidin **(M3)** und 20% 1-(2-Ethylhexyloxy)-4-methoxy-2,5-bis-(4-brom-2,5-dimethoxystyryl)-benzol (**M4)**:

1.2888 g (2.0 mmol). **EM4,** 0.5300 g (0.8 mmol) **EM3,** 0.3035 g (0.2 mmol) **M3**, 0.5748 g (0.8 mmol) **M4**, 2.0300 g (8.8 mmol) K₃PO₄·H₂O, 6 mL Toluol, 19 mL Dioxan und 12.5 mL Wasser wurden 30 min durch Durchleiten von Argon entgast. Anschließend wurden 3.65 mg (12 µmol) Tris-o-tolylphosphin und 0.45 mg (2 µmol) Palladiumacetat unter Schutzgas zugegeben. Die Suspension wurde unter Argonüberlagerung bei 87 °C Innentemperatur (leichter Rückfluß) kräftig gerührt. Nach 20 Minuten wurden noch weitere 15 mL Toluol auf Grund der hohen Viskosität zugegeben. Nach 30 Minuten wurden 12 mg 3,4-Bis(2-methylbutyloxy)benzol-boronsäure zugesetzt. Nach weiteren 60 Minuten Erhitzen wurden 20 mg 3,4-Bis-(2-methylbutyloxy)-brombenzol zugesetzt und noch 60 Minuten zum Rückfluß erhitzt. Die Reaktionslösung wurde mit 5%iger wäßriger Natriumdiethyldithiocarbamat Trihydrat Lösung 4 h bei 65 °C verrührt. Die organische Phase wurde dreimal mit H₂O gewaschen und durch Eintropfen in 200 mL Methanol gefällt. Das Polymer wurde in 120 mL) Toluol gelöst, über Celite filtriert, mit 200 mL MeOH ausgefällt, gewaschen und im Vakuum bis zur Massenkonstanz getrocknet. Man erhielt 2.1 g (95%) des Polymers **P3** als gelblichen Feststoff.
¹H NMR (CDCl₃): [ppm] 8.1-6.8 (m, 12.8 H, DHP, TAD arom.); 6.3 (br.s, 1.4 H, DHP); 4.1-3.6 (3 x m, 3.4 H, OCH₂, OCH₃); 3.0-2.5 (3 x m, 4.2 H, OCH₃ DHP); 1.9-0.7 (m, 17.4 Alkyl H, darunter bei 1.3 *t-*Butyl).
GPC: THF; 1 mL/min, PLgel 10 µm mixed-B 2 x 300 x 7.5 mm², 35°C, RI Detektion: Mw = 207 000 g/mol, Mn = 58 000 g/mol.

### B 2: Synthese von Polymer P4

Polymerisation von 2,7-Dibrom-9,10-bis-(*t-*butylphenyl)-9,10-dimethoxy-9,10-dihydrophenanthren **(EM3)** gemäß Yamamoto (gemäß WO 04/022626):

### Herstellung der Katalysator-Lösung:

Mangan (0.11 g, 2 mmol) wurde mit in 5 mL DMF gelöstem NiBr₂ (200 mg, 0.9 mmol) bei Raumtemperatur gemischt. Die Liganden-Lösung, bestehend aus 150 mg (0.96 mmol) Bipyridin und 0.12 mL (1.0 mmol) COD gelöst in 15 mL Toluol wurde langsam zugegeben. Nach 5-10 Minuten wurde die Lösung tiefviolett. Die Mischung wurde 12 h bei Raumtemperatur kräftig gerührt.
Mangan (350 mg, 6.4 mmol) und die Katalysator-Lösung (2 mL) wurden 10 Minuten bei 50 °C unter Argon gerührt. Die Mischung blieb stabil violett. Dann wurden das Monomer (1.06 g, 1.6 mmol) **EM3** in 16 mL Toluol gelöst zugegeben; dabei färbte sich die Reaktionsmischung rot und wurde anschließend für fünf Tage bei 50°C gerührt. Das Gemisch wurde auf Raumtemperatur abgekühlt, mit 10 mL Toluol verdünnt und über Celite filtriert. Die organische Phase wurde dreimal mit HCl (50 mL) und mit H₂O gewaschen und durch Eintropfen in 500 mL Methanol gefällt. Das Polymer wurde in 50 mL Toluol gelöst, mit 500 mL MeOH ausgefällt, gewaschen und im Vakuum getrocknet. Das Polymer wurde 48 h in einem Gemisch aus THF/MeOH 1:1 soxhletiert, in 50 mL Toluol gelöst und in 500 mL Methanol ein weiteres Mal umgefällt, abgesaugt und bis zur Massenkonstanz getrocknet. Man erhielt 0.6 g (75%) **P4** als blaßgelben Feststoff.
¹H NMR (CDCl₃): [ppm] 8.1-6.9 (m, 12 H); 6.7 (br s, 2 H); 2.9-2.5 (m, 6 H, OCH₃); 1.4-1.1 (m, 18 Alkyl H).
GPC: THF; 1 ml/min, Plgel 10µm Mixed-B 2 x 300 x 7.5 mm², 35 °C, RI Detektion: Mw = 135 000 g/mol, Mn = 30 000 g/mol.

Auf die gleiche Weise wurden weitere Comonomere eingebaut und so weitere rot, grün und blau emittierende Polymere hergestellt. Ebenso wurden Vergleichspolymere (im folgenden mit **V** bezeichnet) synthetisiert, die statt Einheiten gemäß Formel (lb) Spirobifluoren-Einheiten enthalten.
Alle diese Polymere wurden auch für einen Einsatz in PLEDs untersucht. Diese PLEDs waren jeweils Zweischichtsysteme, d. h. Substrat//ITO//PEDOT//Polymer//Kathode. PEDOT ist ein Polythiophen-Derivat (von H.C. Stark, Goslar). Als Kathode wurde in allen Fällen Ba/Ag verwendet. Wie PLEDs dargestellt werden können, ist bereits in WO 04/037887 und der darin zitierten Literatur ausführlich beschrieben.
Die wichtigsten Device-Eigenschaften der erfindungsgemäßen Polymere (Farbe, Effizienz, Betriebsspannung, Lebensdauer) sind in Tabelle 1 aufgeführt und sind den Vergleichspolymeren gegenübergestellt, die keine Einheiten gemäß Formel (lb) enthalten.

**Tabelle 1: Eigenschaften von Poly(dihydrophenanthrenen) und deren Vergleich mit Poly(spirofluorenen); alle Polymere wurden über eine Suzuki-Polymerisation hergestellt.**

| Anteil der Monomere in der Polymerisation [%] | | | | | | GPC* | | Elektrolumineszenz | | | | |
|---|---|---|---|---|---|---|---|---|---|---|---|---|
| Erfindungsgemäße Polymere mit Dihydrophenanthreneinheiten | | | | | | | | | | | | |
| | | | | | | M_{W} / g/mol | M_{N} / g/mol | λₘₐₓ [nm] | Max. Eff. [Cd/A] | Spannung bei 100 Cd/m² [V] | CIE Koordinaten | Lebensdauer bei 100 Cd/m² [h] |
| P1 | 50 (EM4) | 40 (EM3) | 10 (M3) | | | 1476000 | 355000 | 461 | 4.40 | 4.0 | 0.16/0.15 | 1700 |
| P2 | 50 (EM4) | 30 (EM3) | 10 (M3) | 10 (M5) | | 194000 | 67800 | 467 | 2.09 | 4.1 | 0.16/0.18 | 1900 |
| P3 | 50 (EM4) | 20 (EM3) | 10 (M3) | | 20 (M4) | 360000 | 43000 | 522 | 12.0 | 3.3 | 0.30/0.57 | 15000 |
| P4 | 10 (EM7) | 50 (M1) | 30 (M2) | 10 (M3) | | 419000 | 132000 | 488 | 4.2 | 4.0 | 0.18/0.31 | 2200 |
| P5 | 30 (EM7) | 50 (M1) | 10 (M2) | 10 (M3) | | 203000 | 34000 | 489 | 3.1 | 4.3 | 0.18/0.31 | 3600 |

| Vergleichspolymere mit Spirobifluoreneinheiten, wie in WO 03/020790 beschrieben | | | | | | | | | | | | |
|---|---|---|---|---|---|---|---|---|---|---|---|---|
| | M1 | M2 | M3 | M5 | M4 | M_{W} (·1000 g/mol) | M_{N} (·1000 g/mol) | λₘₐₓ [nm] | Max. Eff. [Cd/A] | Spannung bei 100 Cd/m² [V] | CIE Koordinaten | Lebensdauer bei 100 Cd/m² [h] |
| V1 | 50 | 40 | 10 | | | 523000 | 132000 | 454 | 3.30 | 4.4 | 0.16/0.17 | 1250 |
| V2 | 50 | 30 | 10 | 10 | | 306000 | 80500 | 457 | 2.99 | 4.4 | 0.16/0.19 | 1500 |
| V3 | 50 | 20 | 10 | | 20 | 303000 | 64500 | 520 | 10.5 | 3.4 | 0.29/0.56 | 5000 |

| | | | | | | | | | | | | |
|---|---|---|---|---|---|---|---|---|---|---|---|---|
| * GPC Messungen: THF; 1 mL/min, Plgel 10µm Mixed-B 2 x 300 x 7.5 mm², 35 °C, RI Detektion wurde gegen Polystyrol geeicht. | | | | | | | | | | | | |

## Patentansprüche

1. Konjugierte oder teilkonjugierte Polymere, **dadurch gekennzeichnet, dass** sie mindestens 1 mol% Einheiten gemäß Formel (lb) enthalten, 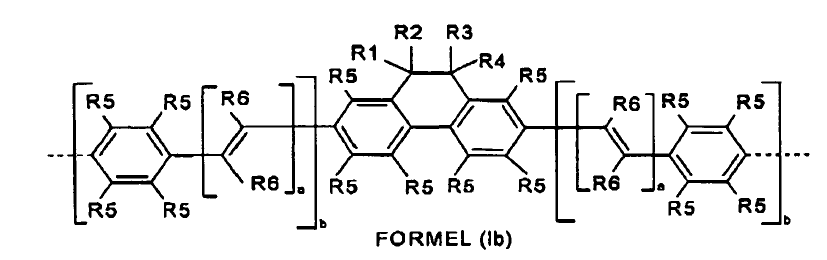 wobei die Symbole und indizes folgende Bedeutung besitzen:
R1, R2, R3, R4 ist bei jedem Auftreten gleich oder verschieden eine geradkettige, verzweigte oder cyclische Alkyl- oder Alkoxykette mit 1 bis 10 C-Atomen, wobei auch ein oder mehrere H-Atome durch Fluor ersetzt sein können, eine Aryl-, Heteroaryl- oder Aryloxygruppe mit 5 bis 14 C-Atomen, in welcher auch ein oder mehrere C-Atome durch N, S oder O ersetzt sein können und welche auch durch einen oder mehrere nicht-aromatische Reste R5 substituiert sein können; mit der Maßgabe, dass nicht zwei Substituenten an einem C-Atom gleichzeitig einer Alkoxy- oder Aryloxyseitenkette entsprechen und nicht alle Substituenten R1 bis R4 gleichzeitig eine Methylgruppe beschreiben;
R5 ist bei jedem Auftreten gleich oder verschieden H, F, CN, N(R6)₂ oder B(R6)₂, eine geradkettige, verzweigte oder cyclische Alkyl- oder Alkoxykette mit 1 bis 22 C-Atomen, in der auch ein oder mehrere nicht benachbarte C-Atome durch O, S, CO-O, O-CO-O, CONR6, Si(R6)₂ ersetzt sein können, wobei auch ein oder mehrere H-Atome durch Fluor ersetzt sein können, eine Aryl-, Heteroaryl- oder Aryloxygruppe mit 5 bis 40 C-Atomen, bei der auch ein oder mehrere C-Atome durch O, S oder N ersetzt sein können und welche auch durch einen oder mehrere nicht-aromatische Reste R5 substituiert sein kann; dabei können auch mehrere Reste R5 oder R5 mit R1 bis R4 ein weiteres Ringsystem bilden;
R6 ist bei jedem Auftreten gleich oder verschieden H, eine geradkettige, verzweigte oder cyclische Alkylkette mit 1 bis 22 C-Atomen, in der auch ein oder mehrere nicht benachbarte C-Atome durch O, S, CO-O, O-CO-O ersetzt sein können, wobei auch ein oder mehrere H-Atome durch Fluor ersetzt sein können, eine Arylgruppe mit 5 bis 40 C-Atomen, bei der auch ein oder mehrere C-Atome durch O, S oder N ersetzt sein können und welche auch durch einen oder mehrere nicht-aromatische Reste R6 substituiert sein kann;
a ist bei jedem Auftreten gleich oder verschieden 0 oder 1;
b ist bei jedem Auftreten gleich oder verschieden 0, 1 oder 2;
die gestrichelte Bindung bedeutet dabei die Verknüpfung im Polymer.

2. Polymere gemäß Anspruch 1, **dadurch gekennzeichnet, dass** sie konjugiert sind.

3. Polymere gemäß Anspruch 1 oder 2, **dadurch gekennzeichnet, daß** diese noch zusätzlich Einheiten enthalten, welche die Lochinjektions- und/oder -transporteigenschaften deutlich erhöhen.

4. Polymere gemäß Anspruch 3, **dadurch gekennzeichnet, daß** die Einheiten, die Lochtransporteigenschaften aufweisen, aus den Strukturelementen der Triarylaminderivate, Benzidinderivate, Tetraarylen-para-phenylendiaminderivate, Phenothiazinderivate, Phenoxazinderivate, Dihydrophenazinderivate, Thianthrenderivate, Dibenzo-p-dioxinderivate, Phenoxathiinderivate, Carbazolderivate, Azulenderivate, Thiophenderivate, Pyrrolderivate, Furanderivate und weitere O-, S- oder N-haltigen Heterocyclen mit hochliegendem HOMO ausgewählt sind.

5. Polymere gemäß einem oder mehreren der Ansprüche 1 bis 4, **dadurch gekennzeichnet, daß** diese noch zusätzlich Einheiten enthalten, welche die Elektroneninjektions- und/oder -transporteigenschaften deutlich erhöhen.

6. Polymere gemäß Anspruch 5, **dadurch gekennzeichnet, daß** die Einheiten, die Elektronentransporteigenschaften aufweisen, aus den Strukturelementen der Pyridinderivate, Pyrimidinderivate, Pyridazinderivate, Pyrazinderivate, Anthracenderivate, Triarylborane, Oxadiazolderivate, Chinolinderivate, Chinoxalinderivate, Phenazinderivate, Arylborane und weiterer O-, S- oder N-haltigen Heterocyclen mit niedrig liegendem LUMO, ausgewählt sind.

7. Polymere gemäß einem oder mehreren der Ansprüche 1 bis 6, **dadurch gekennzeichnet, daß** diese Einheiten enthalten, die Kombinationen von Einzeleinheiten gemäß den Ansprüchen 4 und 6 aufweisen.

8. Polymere gemäß einem oder mehreren der Ansprüche 1 bis 7, **dadurch gekennzeichnet, daß** diese Einheiten enthalten, welche die Emissionscharakteristik insoweit verändern, daß statt Elektrofluoreszenz Elektrophosphoreszenz erhalten werden kann.

9. Polymere gemäß Anspruch 8, **dadurch gekennzeichnet, daß** die Einheiten, welche einen Transfer von sogenannten Singulett-Excitonen zu Triplett-Excitonen ermöglichen und welche auch bei Raumtemperatur mit hoher Effizienz aus dem Triplettzustand Licht emittieren, aus Verbindungen ausgewählt sind, welche Schweratome mit einer Ordnungszahl von mehr als 36 enthalten.

10. Polymere gemäß Anspruch 9, **dadurch gekennzeichnet, daß** die Schweratome aus den Elementen der 8. bis 10. Gruppe (d. h. Ru, Os, Rh, Ir, Pd, Pt) ausgewählt sind.

11. Polymere gemäß einem oder mehreren der Ansprüche 1 bis 10, **dadurch gekennzeichnet, daß** diese zusätzlich Einheiten enthalten, welche den Übergang vom Singulett- zum Triplett-Zustand erleichtern.

12. Polymere gemäß Anspruch 11, **dadurch gekennzeichnet, daß** die Struktureinheiten, die den Übergang vom Singulett- zum Triplett-Zustand erleichtern, aus der Gruppe der Carbazole oder der überbrückten Carbazoldimere ausgewählt sind.

13. Polymere gemäß einem oder mehreren der Ansprüche 1 bis 12, **dadurch gekennzeichnet, daß** weitere Einheiten, welche die Morphologie oder auch die Emissionsfarbe der resultierenden Polymere beeinflussen, verwendet werden, die ausgewählt sind aus aromatischen Strukturen, die 6 bis 40 C-Atome aufweisen und/oder Stilben-, Bisstyrylarylen- oder Tolanderivaten, die jeweils mit einem oder mehreren nicht aromatischen Resten R1 substituiert sein können.

14. Polymere gemäß Anspruch 13, **dadurch gekennzeichnet, daß** die beschriebenen Strukturelemente ausgewählt sind aus 1,4-Phenylen-, 1,4-Naphthylen-, 1,4- oder 9,10-Anthracenylen-, 1,6- oder 2,7- oder 4,9-Pyrenylen-, 3,9- oder 3,10-Perylenylen-, 2,7- oder 3,6-Phenanthrenylen-, 4,4'-Biphenylylen-, 4,4"-Terphenylylen-, 4,4'-Bi-1,1'-naphthylylen-, 4,5-Dihydropyren-, 4,5,9,10-Tetrahydropyren-, Fluoren-, Spirobifluoren-, 5,7-Dihydrodibenzooxepin-, cis- oder trans-Indenofluoren-, 4,4'-Stilben-, 4,4"-Bisstyrylarylen oder 4,4'-Tolanderivaten.

15. Polymere gemäß einem oder mehreren der Ansprüche 1 bis 14, **dadurch gekennzeichnet, daß** im Durchschnitt mindestens 2 nicht-aromatische C-Atome in den Substituenten R1 bis R4 vorhanden sind.

16. Polymere gemäß einem oder mehreren der Ansprüche 1 bis 15, **dadurch gekennzeichnet, daß** keine langkettigen Substituenten mit mehr als 12 C-Atomen in einer linearen Kette vorhanden sind.

17. Polymere gemäß einem oder mehreren der Ansprüche 1 bis 16, **dadurch gekennzeichnet, daß** für die Symbole in Formel (lb) gilt:
R5 ist bei jedem Auftreten H;
R1, R3 sind bei jedem Auftreten gleich oder verschieden eine geradkettige oder verzweigte Alkylkette mit 1 bis 8 C-Atomen oder eine Arylgruppe mit 5 bis 10 C-Atomen, in welcher auch ein oder mehrere C-Atome durch N, S und/oder O substituiert sein können und welche auch durch ein oder mehrere nicht-aromatische Reste R5 substituiert sein können;
R2, R4 sind bei jedem Auftreten gleich oder verschieden eine geradkettige oder verzweigte Alkoxykette mit 1 bis 8 C-Atomen;
a ist bei jedem Auftreten 1, falls die Einheiten gemäß Formel (lb) als Emitter verwendet werden;
b ist bei jedem Auftreten gleich 1, falls die Einheiten gemäß Formel (lb) als Emitter verwendet werden; ansonsten ist b bei jedem Auftreten gleich 0;
die anderen Symbole sind wie in Anspruch 1 definiert.

18. Polymere gemäß einem oder mehreren der Ansprüche 1 bis 17, **dadurch gekennzeichnet, dass** die Struktureinheiten gemäß Formel (lb) aus den Formeln (LXXIX) bis (CVI) ausgesucht sind:

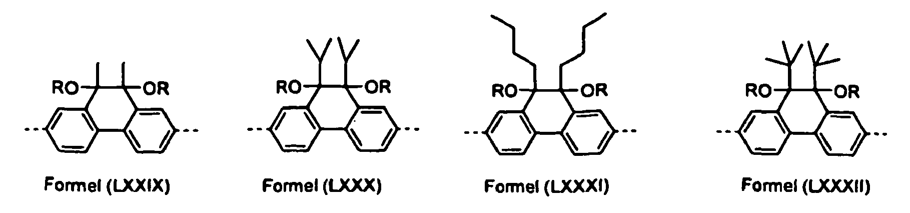

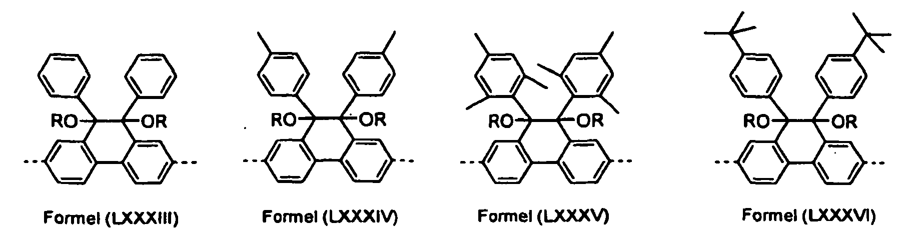

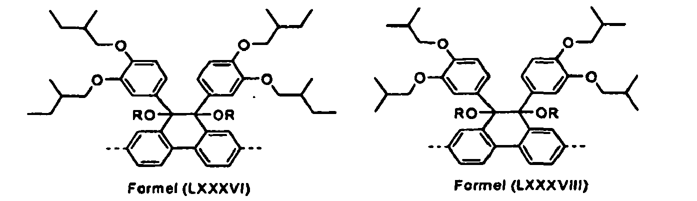

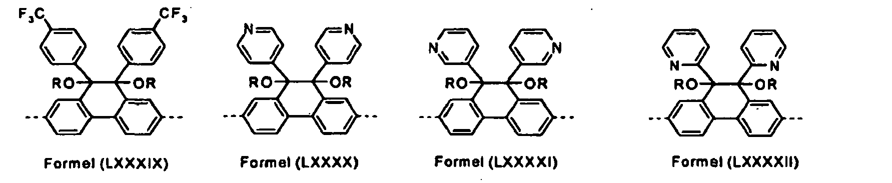

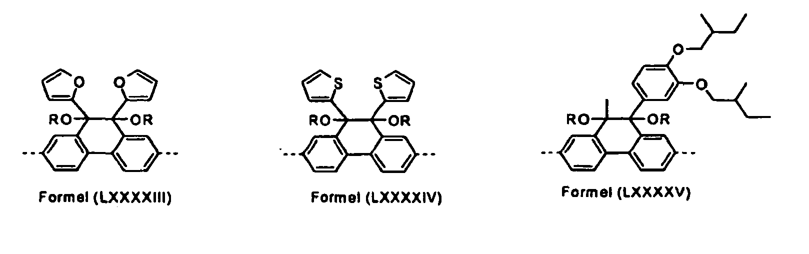

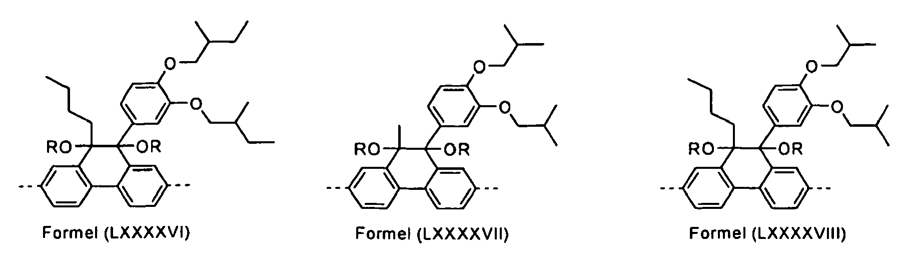

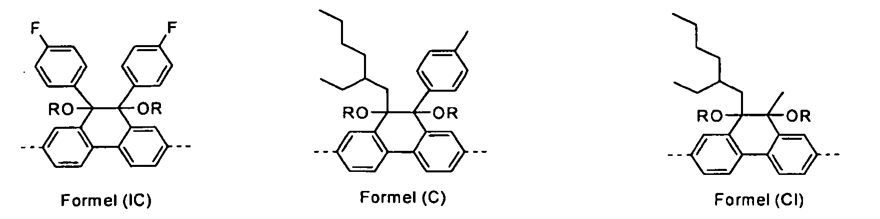

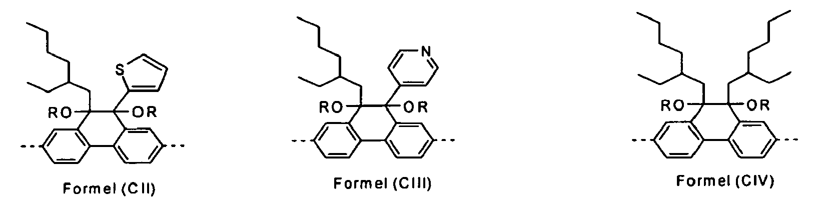

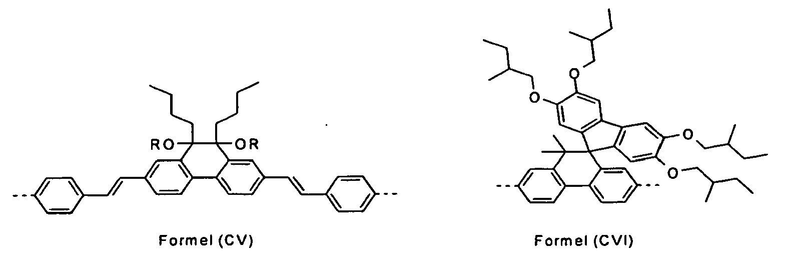

19. Polymere gemäß einem oder mehreren der Ansprüche 1 bis 18, **dadurch gekennzeichnet, dass** sie mindestens 40 mol% Einheiten gemäß Formel (lb) enthalten.

20. Blends (Mischungen), enthaltend ein oder mehrere Polymere gemäß einem oder mehrerer der Ansprüche 1 bis 19.

21. Lösungen, enthaltend ein oder mehrere Polymere oder Blends gemäß einem oder mehrerer der Ansprüche 1 bis 20 in einem oder mehreren Lösemitteln.

22. Verwendung eines Polymers gemäß einem oder mehreren der Ansprüche 1 bis 20 in organischen elektronischen Vorrichtungen, insbesondere als Elektrolumineszenzmaterial in einer PLED.

23. Organische elektronische Vorrichtung mit einer oder mehreren aktiven Schichten, wobei mindestens eine dieser aktiven Schichten ein oder mehrere Polymere gemäß einem oder mehreren der Ansprüche 1 bis 20 enthält.

24. Organische elektronische Vorrichtung gemäß Anspruch 23, **dadurch gekennzeichnet, dass** es sich um eine polymere lichtemittierende Diode (PLED), eine organische integrierte Schaltung (O-IC), einen organischen Feld-Effekt-Transistor (OFET), einen organischen Dünnfilmtransistor (OTFT), eine organische Solarzelle (O-SC), einen organischen Photorezeptor oder eine organische Laserdiode (O-Laser) handelt.

## Claims

1. Conjugated or partially conjugated polymers, **characterised in that** they contain at least 1 mol% of units of the formula (lb) 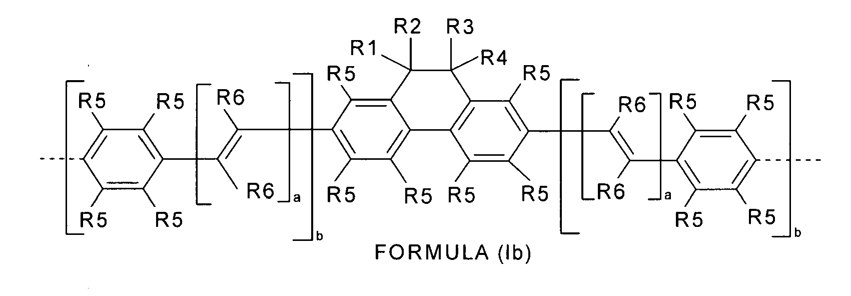 where the symbols and indices have the following meaning:
R1, R2, R3, R4 are on each occurrence, identically or differently, a straight-chain, branched or cyclic alkyl or alkoxy chain having 1 to 10 C atoms, where, in addition, one or more H atoms may be replaced by fluorine, or an aryl, heteroaryl or aryloxy group having 5 to 14 C atoms, in which, in addition, one or more C atoms may be replaced by N, S or O and which may also be substituted by one or more non-aromatic radicals R5; with the proviso that two substituents on a C atom do not simultaneously correspond to an alkoxy or aryloxy side chain and not all substituents R1 to R4 simultaneously describe a methyl group;
R5 is on each occurrence, identically or differently, H, F, CN, N(R6)₂ or B(R6)₂, a straight-chain, branched or cyclic alkyl or alkoxy chain having 1 to 22 C atoms, in which, in addition, one or more non-adjacent C atoms may be replaced by O, S, CO-O, O-CO-O, CONR6, Si(R6)₂, where, in addition, one or more H atoms may be replaced by fluorine, or an aryl, heteroaryl or aryloxy group having 5 to 40 C atoms, in which, in addition, one or more C atoms may be replaced by O, S or N and which may also be substituted by one or more non-aromatic radicals R5; a plurality of radicals R5 or R5 with R1 to R4 may also form a further ring system;
R6 is on each occurrence, identically or differently, H, a straight-chain, branched or cyclic alkyl chain having 1 to 22 C atoms, in which, in addition, one or more non-adjacent C atoms may be replaced by O, S, CO-O, O-CO-O, where, in addition, one or more H atoms may be replaced by fluorine, or an aryl group having 5 to 40 C atoms, in which, in addition, one or more C atoms may be replaced by O, S or N and which may also be substituted by one or more non-aromatic radicals R6;
a is on each occurrence, identically or differently, 0 or 1;
b is on each occurrence, identically or differently, 0, 1 or 2;
the dashed bond here denotes the link in the polymer.

2. Polymers according to Claim 1, **characterised in that** they are conjugated.

3. Polymers according to Claim 1 or 2, **characterised in that** they additionally contain units which significantly enhance the hole-injection and/or -transport properties.

4. Polymers according to Claim 3, **characterised in that** the units which have hole-transport properties are selected from the structural elements of triarylamine derivatives, benzidine derivatives, tetraarylene-para-phenylenediamine derivatives, phenothiazine derivatives, phenoxazine derivatives, dihydrophenazine derivatives, thianthrene derivatives, dibenzo*-p*-dioxin derivatives, phenoxathiine derivatives, carbazole derivatives, azulene derivatives, thiophene derivatives, pyrrole derivatives, furan derivatives and further O-, S- or N-containing heterocycles having a high HOMO.

5. Polymers according to one or more of Claims 1 to 4, **characterised in that** they additionally contain units which significantly enhance the electron-injection and/or -transport properties.

6. Polymers according to Claim 5, **characterised in that** the units which have electron-transport properties are selected from the structural elements of pyridine derivatives, pyrimidine derivatives, pyridazine derivatives, pyrazine derivatives, anthracene derivatives, triarylboranes, oxadiazole derivatives, quinoline derivatives, quinoxaline derivatives, phenazine derivatives, arylboranes and further O-, S- or N-containing heterocycles having a low LUMO.

7. Polymers according to one or more of Claims 1 to 6, **characterised in that** they contain units which have combinations of individual units according to Claims 4 and 6.

8. Polymers according to one or more of Claims 1 to 7, **characterised in that** they contain units which modify the emission characteristics inasmuch as electro-phosphorescence can be obtained instead of electrofluorescence.

9. Polymers according to Claim 8, **characterised in that** the units which facilitate transfer from so-called singlet excitons to triplet excitons and which emit light from the triplet state with high efficiency even at room temperature are selected from compounds which contain heavy atoms having an atomic number of greater than 36.

10. Polymers according to Claim 9, **characterised in that** the heavy atoms are selected from the elements from groups 8 to 10 (i.e. Ru, Os, Rh, Ir, Pd, Pt).

11. Polymers according to one or more of Claims 1 to 10, **characterised in that** they additionally contain units which simplify transfer from the singlet state to the triplet state.

12. Polymers according to Claim 11, **characterised in that** the structural units which simplify transfer from the singlet state to the triplet state are selected from the group of the carbazoles or bridged carbazole dimers.

13. Polymers according to one or more of Claims 1 to 12, **characterised in that** further units are used which influence the morphology or also the emission colour of the resultant polymers and are selected from aromatic structures which have 6 to 40 C atoms and/or stilbene, bisstyrylarylene or tolan derivatives, each of which may be substituted by one or more non-aromatic radicals R1.

14. Polymers according to Claim 13, **characterised in that** the structural elements described are selected from 1,4-phenylene, 1,4-naphthylene, 1,4- or 9,10-anthracenylene, 1,6- or 2,7- or 4,9-pyrenylene, 3,9- or 3,10-perylenylene, 2,7- or 3,6-phenanthrenylene, 4,4'-biphenylylene, 4,4"-terphenylylene, 4,4'-bi-1,1'-naphthylylene, 4,5-dihydropyrene, 4,5,9,10-tetrahydropyrene, fluorene, spirobifluorene, 5,7-dihydrodibenzooxepine, cis- or trans-indenofluorene, 4,4'-stilbene, 4,4"-bisstyrylarylene or 4,4'-tolan derivatives.

15. Polymers according to one or more of Claims 1 to 14, **characterised in that** on average at least 2 non-aromatic C atoms are present in the substituents R1 to R4.

16. Polymers according to one or more of Claims 1 to 15, **characterised in that** no long-chain substituents having more than 12 C atoms are present in a linear chain.

17. Polymers according to one or more of Claims 1 to 16, **characterised in that** the following applies to the symbols in formula (lb):
R5 is on each occurrence H;
R1, R3 are on each occurrence, identically or differently, a straight-chain or branched alkyl chain having 1 to 8 C atoms or an aryl group having 5 to 10 C atoms, in which, in addition, one or more C atoms may be substituted by N, S and/or O and which may also be substituted by one or more non-aromatic radicals R5;
R2, R4 are on each occurrence, identically or differently, a straight-chain or branched alkoxy chain having 1 to 8 C atoms;
a is on each occurrence 1 if the units of the formula (lb) are used as emitters;
b is on each occurrence equal to 1 if the units of the formula (lb) are used as emitters; otherwise, b is on each occurrence equal to 0;
the other symbols are as defined in Claim 1.

18. Polymers according to one or more of Claims 1 to 17, **characterised in that** the structural units of the formula (lb) are selected from the formulae (LXXIX) to (CVI):

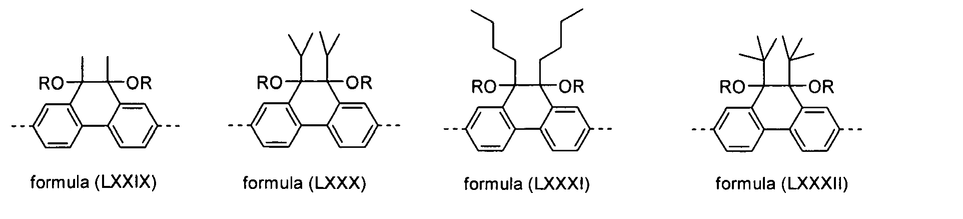

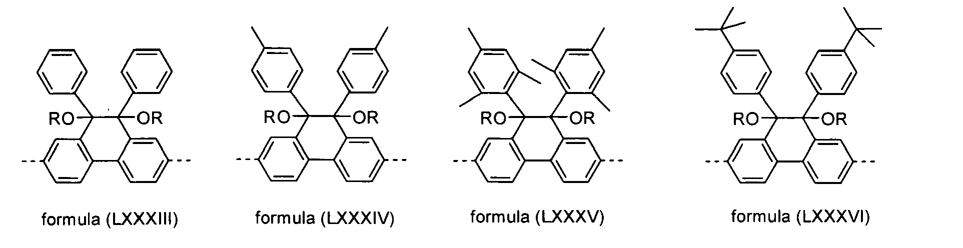

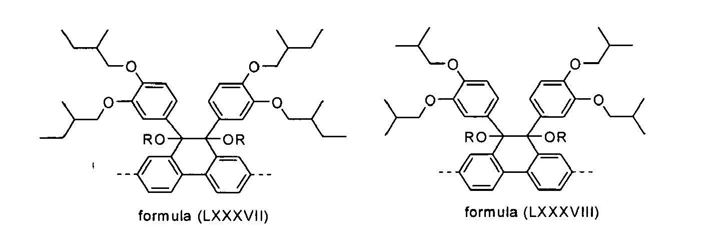

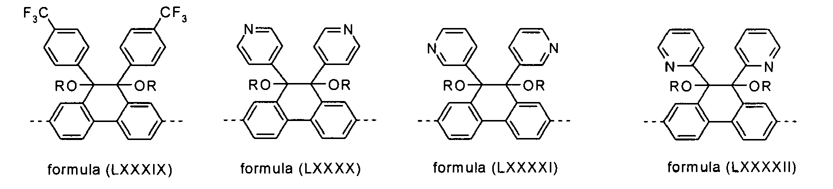

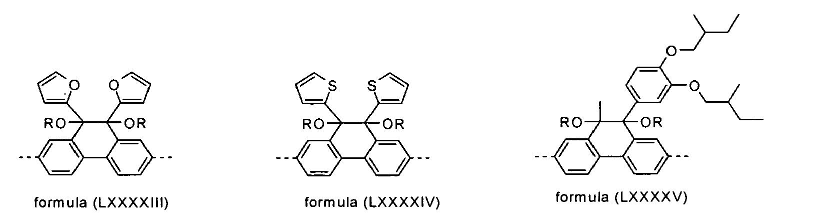

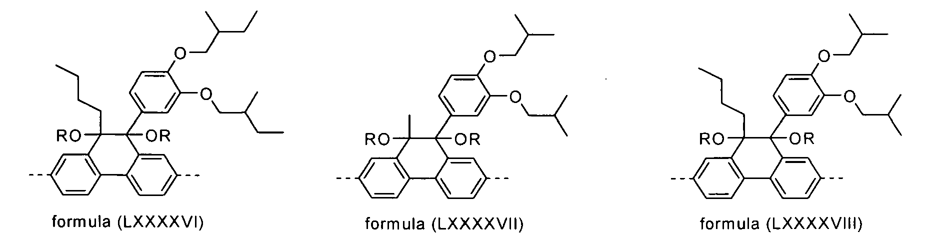

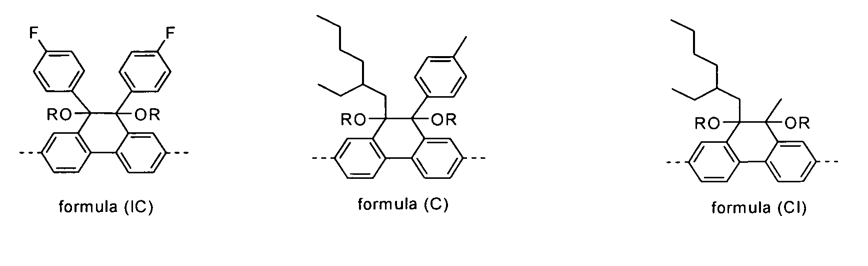

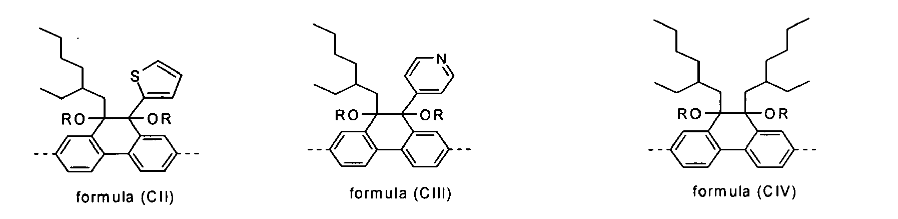

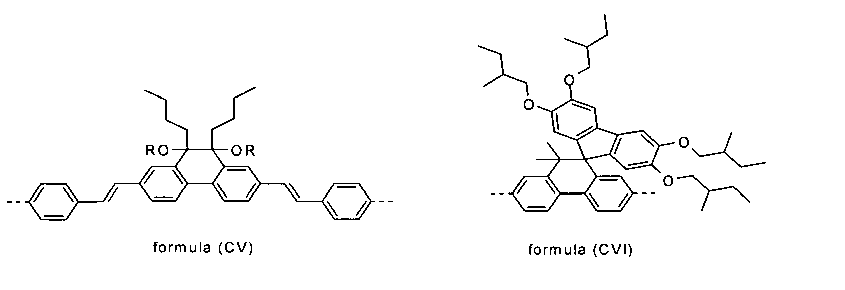

19. Polymers according to one or more of Claims 1 to 18, **characterised in that** they contain at least 40 mol% of units of the formula (lb).

20. Blends (mixtures) comprising one or more polymers according to one or more of Claims 1 to 19.

21. Solutions comprising one or more polymers or blends according to one or more of Claims 1 to 20 in one or more solvents.

22. Use of a polymer according to one or more of Claims 1 to 20 in organic electronic devices, in particular as electroluminescent material in a PLED.

23. Organic electronic device having one or more active layers, where at least one of these active layers comprises one or more polymers according to one or more of Claims 1 to 20.

24. Organic electronic device according to Claim 23, **characterised in that** it is a polymeric light-emitting diode (PLED), an organic integrated circuit (O-IC), an organic field-effect transistor (OFET), an organic thin-film transistor (OTFT), an organic solar cell (O-SC), an organic photoreceptor or an organic laser diode (O-laser).

## Revendications

1. Polymères conjugués ou partiellement conjugués, **caractérisés en ce qu'**ils contiennent au moins 1 %mol. d'unités de la formule (lb) 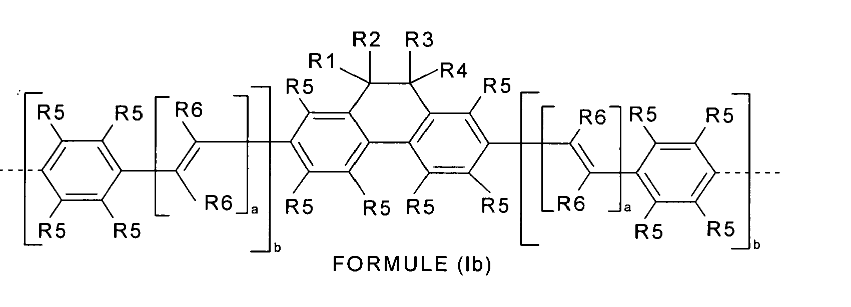 dans laquelle les symboles et indices ont la signification suivante :
R1, R2, R3, R4 sont à chaque occurrence, de façon identique ou différente, une chaîne alkyle ou alcoxy en chaîne droite, ramifiée ou cyclique ayant 1 à 10 atomes de C, où, en addition, un ou plusieurs atomes de H peuvent être remplacés par fluor, ou un groupe aryle, hétéroaryle ou aryloxy ayant 5 à 14 atomes de C, dans lequel, en addition, un ou plusieurs atomes de C peuvent être remplacés par N, S ou O et qui peuvent être substitués par un ou plusieurs radicaux non aromatiques R5; sous réserve que deux substituants sur un atome de C ne correspondent pas simultanément à une chaîne latérale alcoxy ou aryloxy et pas tous les substituants R1 à R4 décrivent simultanément un groupe méthyle ;
R5 est à chaque occurrence, de façon identique ou différente, H, F, CN, N(R6)₂ ou B(R6)₂, une chaîne alkyle ou alcoxy en chaîne droite, ramifiée ou cyclique ayant 1 à 22 atomes de C, dans lequel, en addition, un ou plusieurs atomes de C non adjacents peuvent être remplacés par O, S, CO-O, O-CO-O, CONR6, Si(R6)₂, où, en addition, un ou plusieurs atomes de H peuvent être remplacés par fluor, ou un groupe aryle, hétéroaryle ou aryloxy ayant 5 à 40 atomes de C, dans lequel, en addition, un ou plusieurs atomes de C peuvent être remplacés par O, S ou N et qui peuvent être substitués par un ou plusieurs radicaux non aromatiques R5; une pluralité de radicaux R5 ou R5 avec R1 à R4 peuvent également former un système de cycle supplémentaire ;
R6 est à chaque occurrence, de façon identique ou différente, H, une chaîne alkyle en chaîne droite, ramifiée ou cyclique ayant 1 à 22 atomes de C, dans lequel, en addition, un ou plusieurs atomes de C non adjacents peuvent être remplacés par O, S, CO-O, O-CO-O, où, en addition, un ou plusieurs atomes de H peuvent être remplacés par fluor, ou un groupe aryle ayant 5 à 40 atomes de C, dans lequel, en addition, un ou plusieurs atomes de C peuvent être remplacés par O, S ou N et qui peuvent également être substitués par un ou plusieurs radicaux non aromatiques R6 ;
a est à chaque occurrence, de façon identique ou différente, 0 ou 1;
b est à chaque occurrence, de façon identique ou différente, 0, 1 ou 2;
le lien en pointillés représente ici la liaison dans le polymère.

2. Polymères selon la revendication 1, **caractérisés en ce qu'**ils sont conjugués.

3. Polymères selon la revendication 1 ou 2, **caractérisés en ce qu'**ils contiennent additionnellement des unités qui améliorent de façon significative les propriétés d'injection et/ou de transport de trous.

4. Polymères selon la revendication 3, **caractérisés en ce que** les unités qui ont des propriétés de transport de trous sont choisis parmi les éléments structuraux de dérivés triarylamine, dérivés benzidine, dérivés tétraarylène-para-phénylène-diamine, dérivés phénothiazine, dérivés phénoxazine, dérivés dihydrophénazine, dérivés thianthrène, dérivés dibenzo-p-dioxine, dérivés phénoxathiine, dérivés carbazole, dérivés azulène, dérivés thiophène, dérivés pyrrole, dérivés furanne et d'autres hétérocycles contenant O, S ou N ayant un HOMO élevé.

5. Polymères selon une ou plusieurs des revendications 1 à 4, **caractérisés en ce qu'**ils contiennent additionnellement des unités qui améliorent de façon significative les propriétés d'injection et/ou de transport d'électrons.

6. Polymères selon la revendication 5, **caractérisés en ce que** les unités qui ont des propriétés de transport d'électrons sont choisis parmi les éléments structuraux de dérivés pyridine, dérivés pyrimidine, dérivés pyridazine, dérivés pyrazine, dérivés anthracène, triarylboranes, dérivés oxadiazole, dérivés quinoline, dérivés quinoxaline, dérivés phénazine, arylboranes et d'autres hétérocycles contenant O, S ou N ayant un HOMO bas.

7. Polymères selon une ou plusieurs des revendications 1 à 6, **caractérisés en ce qu'**ils contiennent des unités qui ont des combinaisons d'unités individuelles selon les revendications 4 et 6.

8. Polymères selon une ou plusieurs des revendications 1 à 7, **caractérisés en ce qu'**ils contiennent des unités qui modifient les caractéristiques d'émission pour autant qu'une électrophosphorescence puisse être obtenue à la place de l'électrofluorescence.

9. Polymères selon la revendication 8, **caractérisés en ce que** les unités qui facilitent le transfert depuis ce qu'on appelle des excitons singlets jusqu'à des excitons triplets et qui émettent une lumière à partir de l'état triplet avec une efficience lumineuse même à température ambiante sont choisies parmi des composés qui contiennent des atomes lourds ayant un numéro atomique supérieur à 36.

10. Polymères selon la revendication 9, **caractérisés en ce que** les atomes lourds sont choisis parmi les éléments des groupes 8 à 10 (c'est-à-dire. Ru, Os, Rh, Ir, Pd, Pt).

11. Polymères selon une ou plusieurs des revendications 1 à 10, **caractérisés en ce qu'**ils contiennent additionnellement des unités qui simplifient le transfert depuis l'état singlet jusqu'à l'état triplet.

12. Polymères selon la revendication 11, **caractérisés en ce que** les unités structurelles qui simplifient le transfert depuis l'état singlet jusqu'à l'état triplet sont choisies parmi le groupe des carbazoles ou des dimères de carbazoles pontés.

13. Polymères selon une ou plusieurs des revendications 1 à 12, **caractérisés en ce que** des unités supplémentaires qui influencent la morphologie ou également la couleur d'émission des polymères résultants sont utilisées et sont choisies parmi des structures aromatiques qui ont 6 à 40 atomes de C et/ou des dérivés de stilbène, bisstyrylarylène ou tolane, chacune pouvant être substituée par un ou plusieurs radicaux non aromatiques R1.

14. Polymères selon la revendication 13, **caractérisés en ce que** les éléments structurels décrits sont choisis parmi des dérivés de 1,4-phenylène, 1,4-naphtylène, 1,4- ou 9,10-anthracénylène, 1,6- ou 2,7- ou 4,9-pyrénylène, 3,9- ou 3,10-pérylénylène, 2,7- ou 3,6-phénanthrénylène, 4,4'-biphénylylène, 4,4"-terphénylylène, 4,4'-bi-1,1'-naphtylylène, 4,5-dihydropyrène, 4,5,9,10-tétrahydropyrène, fluorène, spirobifluorène, 5,7-dihydrodibenzooxépine, cis- ou trans-indénofluorène, 4,4'-stilbène, 4,4"-bisstyrylarylène ou 4,4'-tolane.

15. Polymères selon une ou plusieurs des revendications 1 à 14, **caractérisés en ce que** en moyenne au moins 2 atomes de C non aromatiques sont présents dans les substituants R1 à R4.

16. Polymères selon une ou plusieurs des revendications 1 à 15, **caractérisés en ce qu'**aucun substituant en chaîne longue ayant plus de 12 atomes de C n'est présent dans une chaîne linéaire.

17. Polymères selon une ou plusieurs des revendications 1 à 16, **caractérisés en ce que** ce qui suit s'applique aux symboles dans la formule (lb):
R5 est à chaque occurrence H ;
R1, R3 sont à chaque occurrence, de façon identique ou différente, une chaîne alkyle en chaîne droite ou ramifiée ayant 1 à 8 atomes de C ou un groupe aryle ayant 5 à 10 atomes de C, dans lequel, en addition, un ou plusieurs atomes de C peuvent être substitués par N, S et/ou O et qui peuvent être également substitués par un ou plusieurs radicaux non aromatiques R5 ;
R2, R4 sont à chaque occurrence, de façon identique ou différente, une chaîne alcoxy en chaîne droite ou ramifiée ayant 1 à 8 atomes de C ;
a est à chaque occurrence 1 si les unités de la formule (lb) sont utilisées comme émetteurs ;
b est à chaque occurrence égal à 1 si les unités de la formule (lb) sont utilisées comme émetteurs ; et sinon, b est à chaque occurrence égal à 0 ;
les autres symboles sont comme définis dans la revendication 1.

18. Polymères selon une ou plusieurs des revendications 1 à 17, **caractérisés en ce que** les unités structurelles de la formule (lb) sont choisies parmi les formules (LXXIX) à (CVI) :

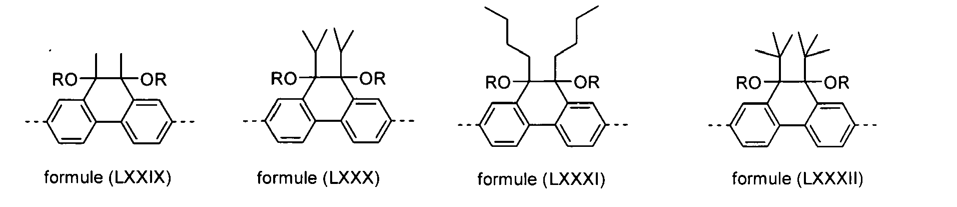

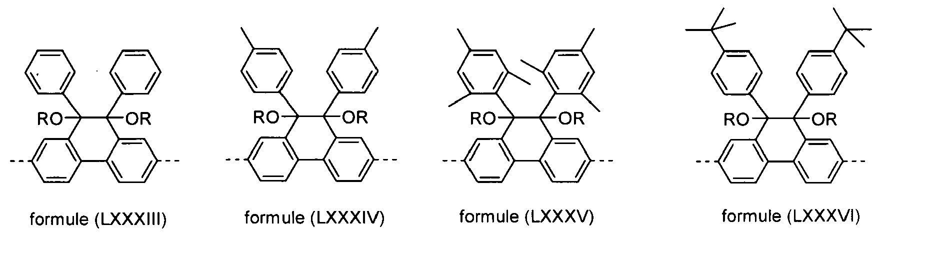

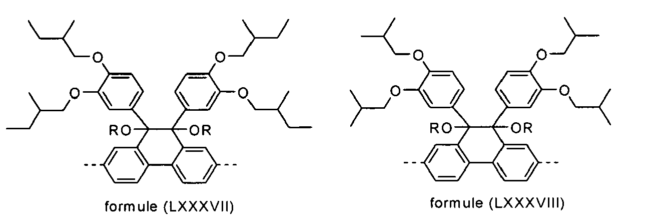

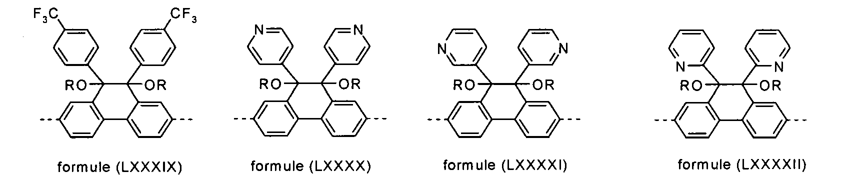

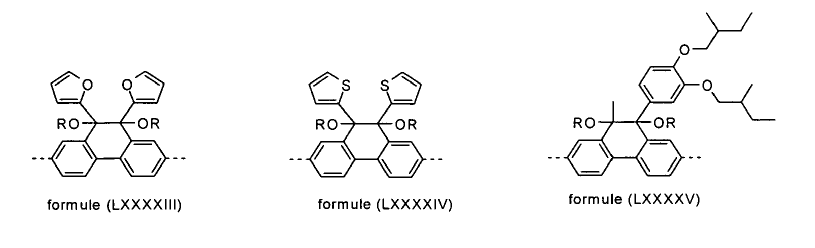

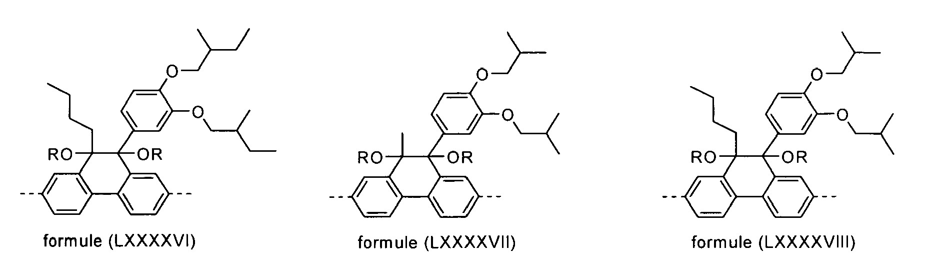

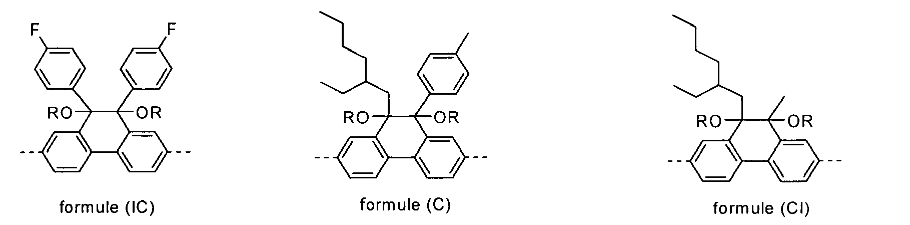

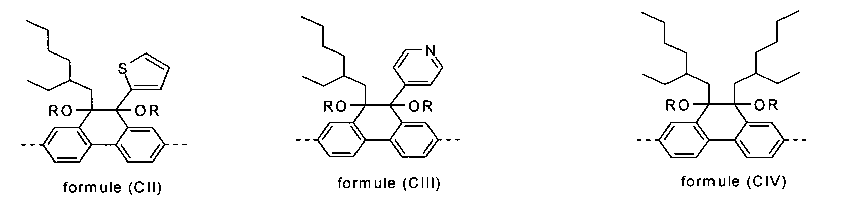

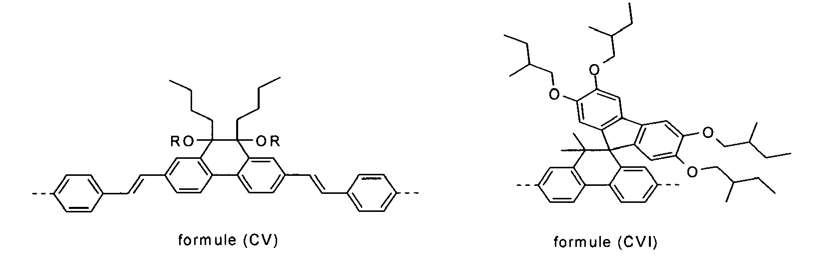

19. Polymères selon une ou plusieurs des revendications 1 à 18, **caractérisés en ce qu'**ils contiennent au moins 40 %mol. d'unités de la formule (Ib).

20. Mélanges (mixtures) comprenant un ou plusieurs polymères selon une ou plusieurs des revendications 1 à 19.

21. Solutions comprenant un ou plusieurs polymères ou mélanges selon une ou plusieurs des revendications 1 à 20 dans un ou plusieurs solvants.

22. Utilisation d'un polymère selon une ou plusieurs des revendications 1 à 20 dans des dispositifs électroniques organiques, en particulier en tant que matériau électroluminescent dans une PLED.

23. Dispositif électronique organique comprenant une ou plusieurs couches actives, dans lequel au moins une de ces couches actives comprend un ou plusieurs polymères selon une ou plusieurs des revendications 1 à 20.

24. Dispositif électronique organique selon la revendication 23, **caractérisé en ce qu'**il est une diode émettrice de lumière polymérique (PLED), un circuit intégré organique (O-IC), un transistor à effet de champ organique (OFET), un transistor à film mince organique (OTFT), une cellule solaire organique (O-SC), un photorécepteur organique ou une diode laser organique (O-laser).
